(19) Europäisches Patentamt
European Patent Office
Office européen des brevets

(11) **EP 4 779 510 A1**

(12) **EUROPEAN PATENT APPLICATION**

(43) Date of publication:
**22.07.2026 Bulletin 2026/30**

(21) Application number: **25305065.2**

(22) Date of filing: **20.01.2025**

(51) International Patent Classification (IPC):
**G06F 30/27** (2020.01)   **G06N 3/045** (2023.01)
**G06V 10/82** (2022.01)

(52) Cooperative Patent Classification (CPC):
**G06F 30/27; G06F 30/10; G06N 3/045;**
**G06N 3/047; G06N 3/088; G06V 10/82**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Dassault Systèmes**
**78140 Vélizy-Villacoublay (FR)**

(72) Inventors:
• **Mezghanni, Mariem**
  **78140 Vélizy-Villacoublay (FR)**
• **Bouzinab, Badr**
  **78140 Vélizy-Villacoublay (FR)**
• **Bergerès, Martin**
  **78140 Vélizy-Villacoublay (FR)**
• **Cotillard, Tristan**
  **78140 Vélizy-Villacoublay (FR)**

(74) Representative: **Bandpay & Greuter**
**11, rue Christophe Colomb**
**75008 Paris (FR)**

(54) **LEARNING A GENERATIVE FUNCTION CONFIGURED TO GENERATE A B-REP GIVEN A CONDITIONING SIGNAL REPRESENTING A GEOMETRY**

(57) The disclosure notably relates to a computer-implemented method of machine-learning, for learning a generative function configured to generate a B-rep given a conditioning signal representing a geometry. The generative function comprises a vertex neural network, an edge neural network, and a face neural network. The edge and face neural network each further comprise a topological model and a geometrical model. Each of the neural network is configured to generate the respective parts of the B-rep (vertices, edges, and faces) respecting the conditioning signal. This provides an improved solution for designing B-reps given a conditioning signal representing a geometry.

**Description**

**TECHNICAL FIELD**

The disclosure relates to the field of computer programs and systems, and more specifically to a method, system and program for learning a generative function configured to generate a B-rep given a conditioning signal representing a geometry.

**BACKGROUND**

A number of solutions, hardware and software, are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for analyzing and simulating the physical behavior of a future product. CAM is an acronym for Computer-Aided Manufacturing, e.g. it relates to software solutions for defining product manufacturing processes and resources. In such computer-aided design solutions, the graphical user interface plays an important role as regards the efficiency of the technique. These techniques may be embedded within Product Lifecycle Management (PLM) solutions. PLM refers to an engineering strategy that helps companies to share product data, apply common processes, and leverage corporate knowledge for the development of products from conception to the end of their life, across the concept of extended enterprise. The PLM solutions provided by Dassault Systèmes (under the trademarks CATIA, SIMULIA, DELMIA and ENOVIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the solutions deliver common models linking products, processes, resources to enable dynamic, knowledge-based product creation and decision support that drives optimized product definition, manufacturing preparation, production and service.

A format widely used in CAD is the B-rep format. B-rep stands for "boundary representation". Designing B-reps is a long process involving combining many different geometric objects and operators, each of which depends on a multitude of parameters. Within this context, there is still a need for improved solutions for B-rep design.

**SUMMARY**

It is therefore provided a computer-implemented method of machine-learning, for learning a generative function configured to generate a B-rep given a conditioning signal. The conditioning signal represents a geometry. The generative function comprises a vertex neural network. The vertex neural network is configured to generate B-rep vertices respecting the conditioning signal. The generative function also comprises an edge neural network. The edge neural network is configured to, given the generated vertices, generate B-rep edges respecting the conditioning signal. The edge neural network comprises an edge topology neural network. The edge topology neural network is configured for generating edge connections between the generated vertices. The edge neural network also comprises an edge geometry neural network. The edge geometry neural network is configured for determining geometries of the generated edge connections. The generative function also comprises a face neural network. The face neural network is configured to, given the generated edges, generate B-rep faces respecting the conditioning signal. The face neural network comprises a face topology neural network. The face topology neural network is configured for generating faces each defined by a sequence of consecutive generated edges forming a face boundary. The face neural network also comprises a face geometry neural network. The face geometry neural network is configured for determining geometries of the generated faces. The learning method also comprises obtaining a training dataset including training examples. Each training example comprises a B-rep and an associated conditioning signal representing a geometry represented by the B-rep. The learning method also comprises training the generative function based on the training dataset. The method may be referred to as "the learning method" in the present disclosure.

The learning method may comprise one or more of the following:

- one or more of the neural networks are based on a transformer neural network architecture;
- each determined geometry of a respective generated edge connection is a line, an arc, a B-spline, or a NURBS and/or each determined geometry of a respective generated face connection is a plane, a cylinder, a torus, a cone, a sphere, or a NURBS;
- the conditioning signal represents an image or a text, said image being a sketch, a picture, or a scan of at least part of an object;
- the generative function includes an encoder, the encoder being configured to take as input the image or the text and encoding it into a vector forming the conditioning signal;

- the edge topology neural network is based on a pointer network and/or the face topology neural network is based on a pointer network;
- one or more neural networks are trained to predict elements one at a time, each prediction using all the previous predictions;
- the one or more neural networks are trained following the method of teacher forcing;
- one or more neural networks are trained to predict all the elements at the same time; and/or
- prior to the training of the neural networks, pre-processing the training dataset, said pre-processing including normalizing the size of the B-reps, removing loops by adding vertices, bounding box centering, and/or sorting vertices, edges and/faces.

It is further provided a generative function obtainable according to the learning method, that is a computer-implemented generative function having the weights of a generative function learnt by the learning method. The provided generative function may for example have been learnt directly by the learning method, with its weights having been fixed by the learning step of the learning method.

It is further provided a computer-implemented method of use of a generative function according to the learning method. The method of use comprises obtaining a conditioning signal representing a geometry. The method of use also comprises applying the generative function to generate a B-rep based on the conditioning signal. The method may be referred to as "the method of use" in the present disclosure.

It is further provided a computer program comprising instructions for performing the learning method and/or the method of use.

It is further provided a device comprising a data storage medium having recorded thereon the computer program and/or the generative function.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g., the device is a subsystem of the overall system). The system may further comprise a graphical user interface coupled to the processor.

## BRIEF DESCRIPTION OF THE DRAWINGS

Non-limiting examples will now be described in reference to the accompanying drawings, where:

- FIG.s 1 to 17 illustrate the method; and

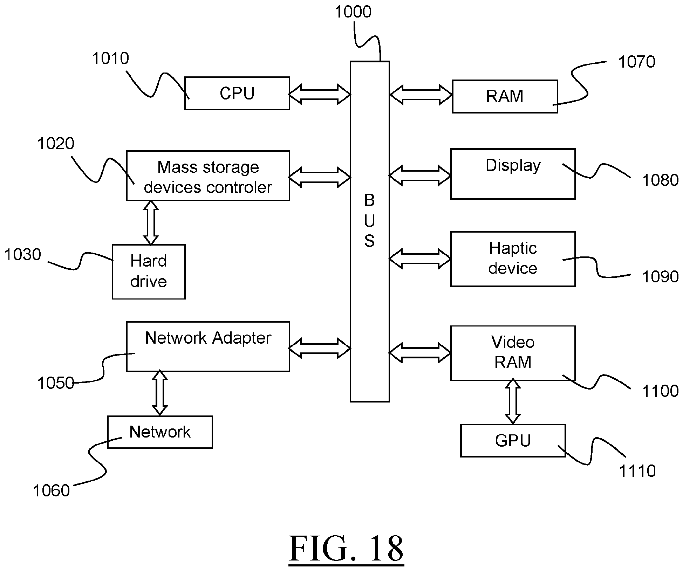

- FIG. 18 shows an example of the system.

## DETAILED DESCRIPTION

It is proposed a computer-implemented method of machine-learning (the learning method), for learning a generative function configured to generate a B-rep given a conditioning signal. The conditioning signal represents a geometry. The generative function comprises a vertex neural network. The vertex neural network is configured to generate B-rep vertices respecting the conditioning signal. The generative function also comprises an edge neural network. The edge neural network is configured to, given the generated vertices, generate B-rep edges respecting the conditioning signal. The edge neural network comprises an edge topology neural network. The edge topology neural network is configured for generating edge connections between the generated vertices. The edge neural network also comprises an edge geometry neural network. The edge geometry neural network is configured for determining geometries of the generated edge connections. The generative function also comprises a face neural network. The face neural network is configured to, given the generated edges, generate B-rep faces respecting the conditioning signal. The face neural network comprises a face topology neural network. The face topology neural network is configured for generating faces each defined by a sequence of consecutive generated edges forming a face boundary. The face neural network also comprises a face geometry neural network. The face geometry neural network is configured for determining geometries of the generated faces. The learning method also comprises obtaining a training dataset including training examples. Each training example comprises a B-rep and an associated conditioning signal representing a geometry represented by the B-rep. The learning method also comprises training the generative function based on the training dataset.

A B-rep (boundary representation) is a CAD format that may directly be used to manufacture an object represented by the B-rep. For example, a CAD format may be automatically converted into manufacturing instructions, such as a CAM file. B-rep may precisely describe the object to be manufactured, and it is therefore a well-established format for designing products to be manufactured. Thus, methods for designing B-reps are very important for the manufacturing process. Designing a B-rep, however, can be time-consuming and requires meticulous attention to detail. The process often involves constructing a feature tree, which is a hierarchical structure that organizes the various features and operations used to build the B-rep model. Each feature must be carefully defined and parameterized to ensure the final model meets the desired specifications. The learning method enables learning a generative function for automatically generating a B-rep given a conditioning signal. The generative function may enable the user to create efficiently B-reps starting from, e.g., images or text, drastically reducing the time required to generate B-reps. The methods thus allow to benefit from the power of generative Artificial Intelligence (AI) to generate B-reps.

Notably, the generative function comprises at least five neural networks, the five neural networks may be distinct or some of them may be combined in a same neural network and thus forming each a subnetwork thereof. For simplicity the neural networks are, however, discussed separately. Each of the neural networks is specialized in generating specific topological and geometric aspects of B-reps. This greatly enhances the generative capability of the generative function learnt in the learning method: the generative function is able to learn and generate B-reps representing complex geometrical patterns. In particular, the edge and face model both comprise topological models and geometrical models. The models learn (i.e., are trained) based on a training dataset comprising B-reps and conditioning signals. The topological edge model learns the topological edge structure of the B-reps used in the training process, that is, the model learns which couples of vertices are connected by edge. Similarly, the topological face model learns the boundary (i.e., contour) of the faces. The respective geometrical models learn the associated equations defining the components. By separating the topological and the geometrical model, the generative function is able to learn and generate complex geometrical equations and parametrizations of the associated topological edges and faces. These complex geometrical equations and parametrizations may be used to obtain B-reps that represent closely the geometry represented by the conditioning signal.

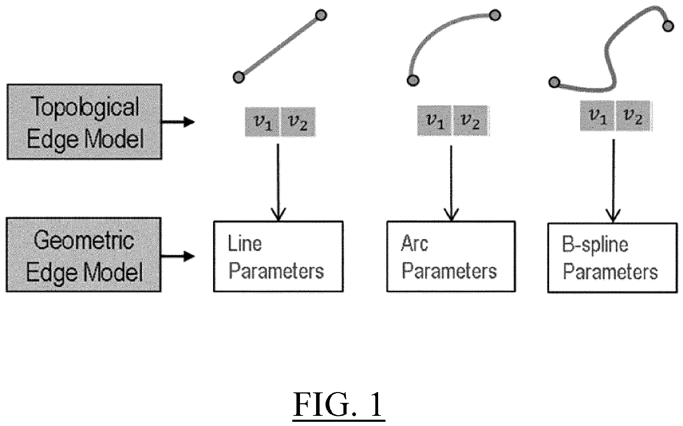

FIG. 1 illustrates how, after the edge topology neural network generates an edge, the edge geometry neural network generates the associated equations determining the geometrical shape of the edge.

By using complex geometrical equations and parametrizations, the learning method is also able to associate to the conditioning signals, B-reps with fewer elements (i.e., small number of vertices, edges, and faces) with respect to methods only using simpler equations. For example, a method only using the linear geometry (e.g., lines) for edges and the linear geometry (e.g., planes) for faces, would require a lot more elements to describe a sphere, as a method able to use rounder geometry (e.g., circles and sections of spheres). Similarly, more complex shapes may require more complicated geometries to be expressed efficiently. B-reps with fewer elements are easier to modify (e.g., they depend on less parameters, said parameters may be easier to interpret), they occupy less memory on the system, they may reproduce more faithfully the geometry represented by the conditioning signal, and may be easier and more efficient to use in further methods. Therefore, the learning method greatly improves the quality of the generated B-reps, and the efficiency of further processing said B-reps.

Specifically, each determined geometry of a respective generated edge connection may be a line, an arc, a B-spline, or a NURBS, and each determined geometry of a respective generated face connection may be a plane, a cylinder, a torus, a cone, a sphere, or a NURBS. In particular, NURBS (Non-uniform rational B-spline) curves and surfaces are capable of modeling both simple shapes and complex free-form shapes, allowing the learning method to learn how to generate B-rep closely based (representing) the conditioning signal representing a geometry. Such generated B-rep may have a lower number of elements (e.g., lower number of vertices, edges, and/or faces) compared to prior art methods.

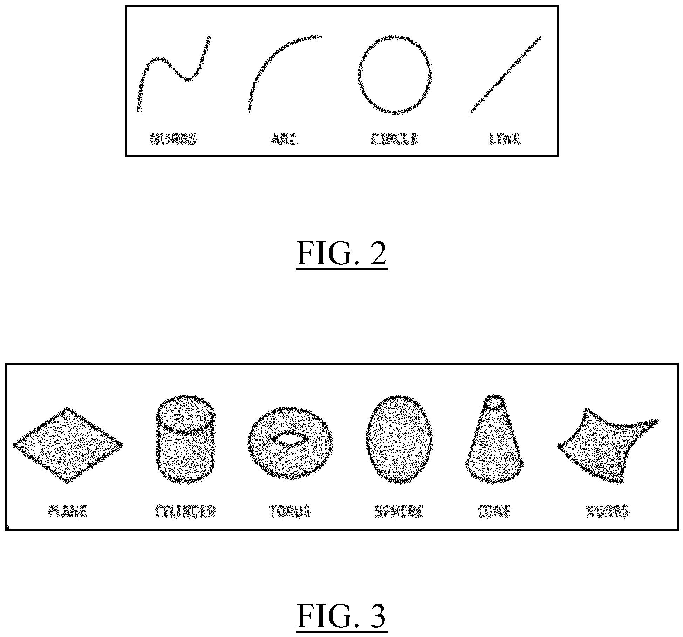

FIG. 2 and 3 (extracted from Pradeep Kumar Jayaraman, Joseph G. Lambourne, Nishkrit Desai, Karl D.D. Willis, Aditya Sanghi, Nigel J.W. Morris "SolidGen: An Autoregressive Model for Direct B-rep Synthesis" TMLR 2023) show examples of the possible geometries of the generated edges and faces, respectively.

It is also proposed a computer-implemented method of use (the method of use) of a generative function according to the learning method. The method of use comprises obtaining a conditioning signal representing a geometry. The method of use also comprises applying the generative function to generate a B-rep based on the conditioning signal.

The learning method and the method of use constitute an improved solution for generating B-reps given a conditioning signal representing a geometry.

Notably, the method of use constitutes a new possible way of generating B-reps, by providing a conditioning signal representing a geometry instead of manually defining the different geometric objects and operators defining a B-rep. The user may also use the method of use several times, each time providing a conditioning signal and obtaining a B-reps, which may be used as a part of a 3D modeled object. The conditioning signal may represent an image of at least a part of an object. In particular, the user may give an image (e.g., an image with low resolution) of an object that is partially not visible (i.e. a partially occluded object) and the method of use may give as an output a B-rep representing the entire object. That is, the method of use may be used to generate portions of B-reps corresponding to portions of non-visible objects in an image. For example, the method of use generates B-reps that are three dimensional, whereas the image may be a two-dimensional representation of the object. The method may also generate a B-rep from an image showing the object in 3D, with the object partially occluded, such that the method performs autocompletion of the image (although the output is not a completed image but a completed corresponding B-rep model). The image may be a digital image, acquired by a camera (the method of use may or may not comprise the acquisition step).

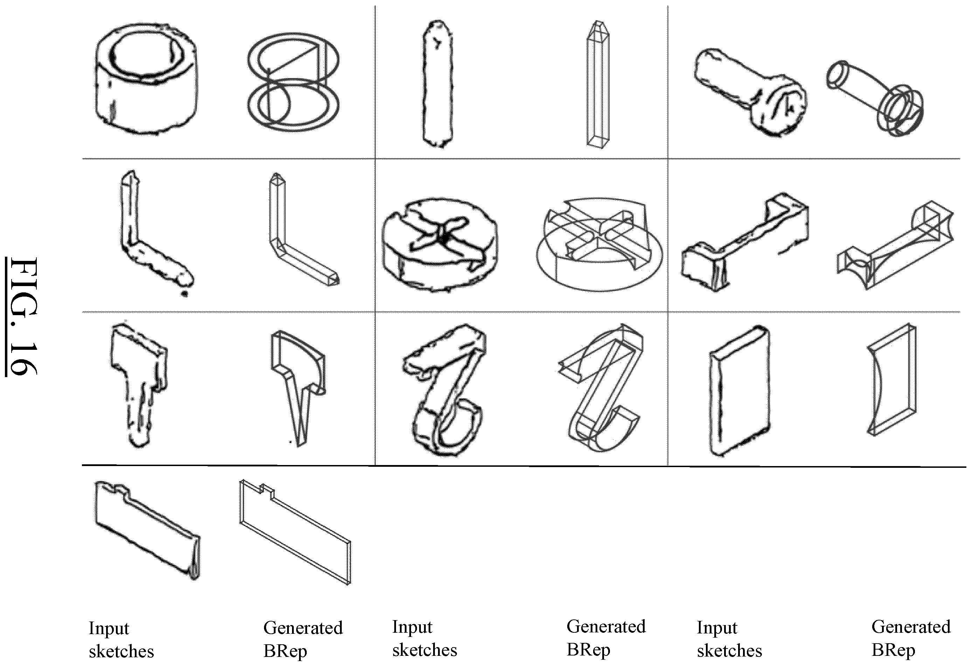

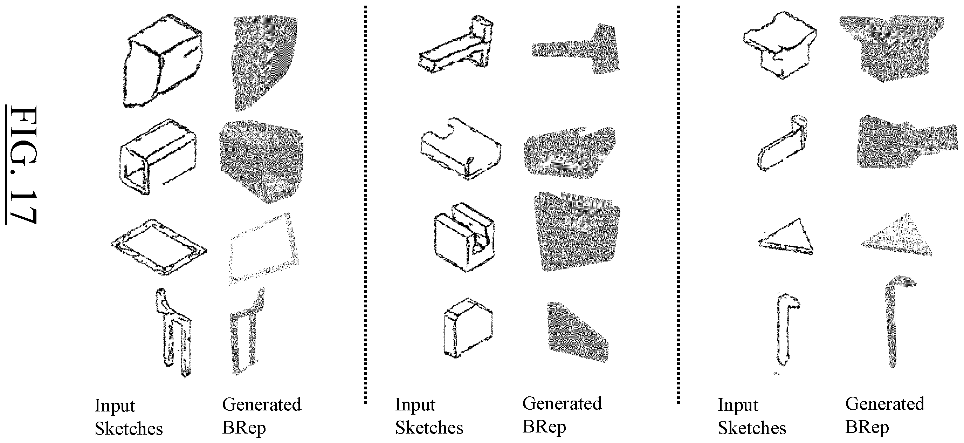

The image may be a sketch. For example, the method of use may comprise obtaining a sketch and automatically generating a B-rep according to the sketch. The sketch may be drawn (e.g., manually or with software) by the user. As drawing a sketch is a very simple and time-efficient process, compared to the more time consuming and technical process of designing a B-rep, the method of use effectively improves the ergonomics of the process of designing a B-rep, by drastically reducing the number of user-interactions necessary to design a B-rep. The method of use was tested with conditioning signals given by sketches, as illustrated in FIG. 16-17, and the resulting B-reps resemble closely the given sketches. These implemented tests are discussed further below in this disclosure. The image may also be a scan of a sketch drawn on paper.

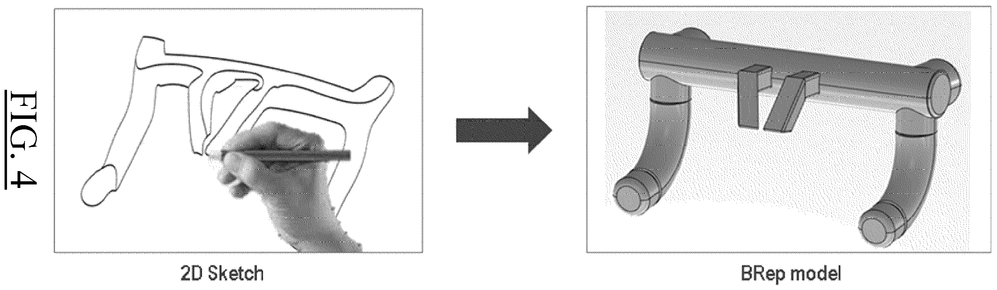

FIG.4 illustrates a possible example of the method of use: the user draws a 2D-sketch, and the method of use automatically generates a (3D) B-rep according to the sketch.

The image may be a picture or a scan. For example, the method of use may comprise obtaining a picture or a scan of at least part of an object (such as a mechanical part), and automatically generate a B-rep representing the object. The generative function may accurately infer part of the shape of the object from the at least part of the object.

The method of use may enable generating a B-rep representing a physical object (such as a mechanical part). The method of use may, therefore, be included in a manufacturing process and/or the output of the method of use may directly be usable for manufacturing the product. For example, the method of use may include, after generating the B-rep, storing the specifications of the B-rep in a file and, optionally, converting them into manufacturing instructions (for example with a known CAD to CAM conversion process) for manufacturing a product modeled by said B-rep. The method of use may also automatically send the manufacturing instructions and/or the stored file to a manufacturing machinery, so that the manufacturing machinery, following the instructions, produces the product represented by the B-rep. The method of use may comprise the physical manufacturing or simply storing manufacturing instructions obtained from the specifications and output of the method of use and/or sending these instructions to the manufacturing process).

The method of use may comprise obtaining a picture or a scan of an object (e.g., a mechanical part), and automatically generating a B-rep representing the object. The method of use may comprise obtaining a picture or a scan of a broken or incomplete object (e.g., a mechanical part), generating a B-rep representing the broken or incomplete object, and determining a B-rep of the entire object. The determining may be manually done by the user, or by any method known in the art. The method of use may, optionally, comprise obtaining manufacturing instruction for the entire object. This may be extremely advantageous to produce copies of objects. For example, a mechanical object may comprise one or more mechanical parts. Some of the mechanical parts may be missing and/or may be broken. The user may use the method of use to produce the missing and/or broken mechanical parts to repair the mechanical object.

The method of use may also allow improving existing (e.g., physical) objects. For example, the method of use may comprise acquiring an image of an object, obtaining a B-rep representing an object, and optimizing the B-rep (e.g., with an optimization program). Optimizing the B-rep may be done with any method known in the art.

The method of use may also comprise annotating or modifying the input image. For example, the method of use may comprise obtaining an image of at least part of an object, modifying (e.g., by drawing) the image to complete the at least part of an object, and automatically generating a B-rep representing the entire object.

The method of use may also enable recovering designs (e.g., B-reps, or CAD models) from visual representations of the designs. The representation of a design may be a picture (e.g., a screenshot). The method of use may therefore enable the user to recover the B-rep of graphical representations of lost designs.

The conditioning signal may also be a text. That is, the user may describe an object with words and the method of use may automatically generate a B-rep according to the description of the user. As writing a text is more efficient than generating a B-rep, this also drastically increases the ergonomics of generating a B-rep.

The learning method is a method of machine-learning, for learning a generative function (also called model). The learning method comprises obtaining a training dataset and training the generative function based on a training dataset. As is known *per se* from the field of machine-learning, the processing of an input by a model includes applying operations to the input, the operations being defined by data including weight values or parameters. Learning a model (e.g., a neural network or a transformer) thus includes determining values of the weights/parameters based on a dataset configured for such learning, such a dataset being possibly referred to as a learning dataset or a training dataset. For that, the dataset includes data pieces each forming a respective training sample or training example. The training samples/examples represent the diversity of the situations where the model is to be used after being learnt. Any training dataset herein may comprise a number of training samples/examples higher than 50000, 100000, or 250000. In the context of the present disclosure, by "learning a model based on a dataset", it is meant that the dataset is a learning/training dataset of the model, based on which the values of the weights/parameters are set. In the present disclosure, the training dataset is the obtained dataset of training examples, on which the model is learnt/trained. In implementations, the training dataset consists of tens of thousands examples each corresponding to a B-rep and an associated conditioning signal.

As is known *per se* from machine-learning, a neural network may be defined by its architecture, parameters, and hyperparameters. The architecture consists of layers, starting with the input layer whose neuron count may be determined by the dimensionality of the input data. This layer is followed by several hidden layers with a given number of neurons and activation functions. These layers and neurons define the network's depth and width, while the activation functions may introduce nonlinearity into the model. The output layer may have as many neurons as the variables in the output data. The interconnections between these layers define the topology of the neural network. The parameters of the neural network are the learnable weights and biases, which are determined in the training process. In contrast, the hyperparameters are pre-defined settings that are not learned from the training data. These encompasses the number of hidden layers, neurons per layer and much more. To train a neural network, at least two settings may be defined. First, a loss function, which is a metric that measures the error between the training data and the model's prediction, such as the mean square error (MSE). Second, an optimizer, which modifies the model's weights and biases during the training process to minimize the loss function. Each optimizer has its own set of hyperparameters.

The learning method is a method of machine-learning, for learning a generative function configured to generate a B-rep.

A B-Rep includes entities (e.g., elements, components) such as topological entities and geometrical entities. Topological entities are: vertices, edges, and faces. Vertices, edges, and faces may sometimes be referred to as topological vertices, topological edges, and topological faces respectively. Geometrical entities are objects in a 3D space: points, curves, and surfaces. Points, curves, and surfaces may sometimes be referred to as geometrical vertices, geometrical edges, and geometrical faces respectively. The topological entities are abstract and/or combinatorial entities and express how the different parts of the B-rep are connected to each other. The edges are determined by their boundary, that is, by two (e.g., distinct) vertices. Two edges are adjacent if they share at least one boundary vertex. Similarly, faces are also determined by their boundary, consisting of a sequence of adjacent (e.g., distinct) edges forming a loop. By adjacent edges forming a loop, it is meant that the edges are given in a cyclic order (i.e., an order wherein each element has a predecessor and a successor), each edge being adjacent to the previous edge and the successor edge. Two faces are adjacent if they share at least an edge in the respective boundaries. Edges and faces also includes a choice of orientation.

The geometrical entities comprise equations and coordinates associated to relative topological entities. That is, each point has coordinates (e.g., in a 3D space) and is associated to a vertex. Each curve is described by an equation (e.g., a parametrization in the 3D space). Each curve is associated with a given edge and is bounded between two points. The two points are associated with the two vertices comprising the boundary of the given edge. Similarly, a surface is described by an equation (e.g., a parametrization in the 3D space). Each surface is associated with a given face and is bounded by one or more curves. The one or more curves are associated with the boundary of the given face.

In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open if it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. Indeed, this is because the representation contains surfaces based only on parameters. In other representations such as meshes, the equivalent surface comprises up to thousands of triangles. Moreover, this is also because a B-Rep doesn't contain any history-based information.

The B-Rep may represent the geometry of the mechanical part or assembly of parts (or equivalently an assembly of parts, as the assembly of parts may be seen as a part itself from the point of view of the methods, or the methods may be applied independently to each part of the assembly), or more generally any rigid body assembly (e.g. a mobile mechanism). The B-Rep may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

The generative function is configured to generate a B-rep given a conditioning signal representing a geometry and the method of use comprises obtaining a conditioning signal representing a geometry. Conditioning, in the context of generative AI models, refers to the process of injecting additional information into the generation process in order to get results which match user-driven constraints. Conditioning can come in various forms, including text (e.g., DALL-E 2, Midjourney, Stable Diffusion) or image (e.g., ControlNet, semantic segmentation). A conditioning signal representing a geometry is an input signal that is used by the generative function and encodes specific geometric information including shapes, sizes, positions, orientations, and spatial relationships between objects and/or structures. For example, the geometry represented by the conditioning signal (e.g., obtained by the method of use) may represent an object or a surface in a 3D space. The conditioning signal may, thus, represent an object/surface in a 3D space. The conditioning signal may comprise a partial illustration of such object/surface, e.g., a representation (e.g., 2D) of the object/surface from a viewpoint. The illustration may also comprise noise or other objects that cover part of the geometry/object/surface and are not intended to be part of the geometry. A conditioning signal may represent point clouds, or other mathematical structures representing a geometry. A conditioning signal may represent images, such as sketches, pictures, or scans. Said images may be images comprising at least part of an object, said object being the geometry to be reproduced (e.g., approximated) by the generative function. A conditioning signal may represent abstractly a geometry, e.g., through a text. A conditioning signal may be an encoded input, such as an encoded image or text.

Notably, the generative function may include an encoder, the encoder being configured to take as input an image and/or a text and encoding it into a vector forming the conditioning signal representing a geometry. The encoder may transform the input image and/or text into a signal (e.g., a vector, e.g., a floating-point vector or a vector with integer coefficients) directly usable by the neural networks comprised in the generative function. Therefore, the encoder may simplify the structure of the generative function. The encoder may be designed to encode an image and a text illustrating the same object in a similar way. By using such an encoder, the generative function may take as input both images and text, without requiring a different training for the different inputs. This further increases the usability of the method. The encoder may be a well-known encoder, for example, the encoder CLIP by Huggin Face. CLIP is an encoder originally developed by OpenAI, and disclosed in https://arxiv.org/pdf/2103.00020. Therefore, the generative function may include an encoder (e.g., CLIP) and the conditioning signal representing a geometry may be an encoded (e.g., with said encoder) illustration. The illustration may be an image (e.g., a sketch, a picture, or a scan of at least part of an object) or text (e.g., a text describing at least part of an object). The image and/or text may represent a geometry (e.g., an object) by illustrating a significant portion of the geometry.

The learning method comprises obtaining a training dataset including training examples. Each training example comprises (e.g., consists of) a B-rep and an associated conditioning signal representing a geometry represented by the B-rep. That is, each training example comprises a B-rep and a conditioning signal both representing a same geometry. The geometry may be an object, for example, an object to be manufactured, such as a mechanical part. For example, a training example may include a conditioning signal consisting in an encoded image (or text) of at least part of an object, and a B-rep representing the object. By B-rep representing a geometry, or an object, it is meant that the B-rep (or a 3D representation of the B-rep) may approximate the object. In particular, at least part of (e.g., all) the B-reps included in the training dataset may be closed.

It is to be understood that a plurality (e.g., seven) of training samples comprised in the training dataset may comprise a same B-rep associated with different conditioning signals, each conditioning signal representing a same geometry represented by the B-rep. The conditioning signals may, e.g., represent the same geometry from different points of view. Additionally or alternatively, one or more of the training samples (e.g., all training samples) comprised in the training dataset may each comprise a conditioning signal representing a geometry represented by the associated B-rep, the conditioning signal comprising a plurality (e.g., seven) of different signals representing the geometry. The plurality of different signals may each represent the geometry from a different point of view. Having a plurality of signals representing a same geometry represented by a same B-rep under different points of view may enable training the generative function to correctly generate a B-rep representing a geometry given a conditioning signal representing the geometry from any of the possible points of view.

Obtaining a training dataset may comprise obtaining training examples, or retrieving from (e.g., local or distant) memory or receiving (e.g., from a remote system) training examples having been thereby stored. Obtaining a training example may include obtaining a B-rep and a representation of the B-rep (e.g., an image of a representation of the B-rep), the representation of the B-rep being used as conditioning signal representing the geometry.

Obtaining a training dataset may comprise obtaining a dataset of B-reps, for each given B-rep comprised in the dataset obtaining one or more representations of the given B-rep, and, optionally, modifying the one or more representations of the given B-rep. Modifying a representation of a given B-rep may include adding noise, reducing quality, reducing details, and/or reducing resolution. Modifying a representation may comprise any method of processing images, e.g., turning the image into a sketch. Obtaining a training dataset may, thus, comprise defining training examples using said B-reps and representations (e.g., modified representations). Therefore, obtaining the training dataset may comprise defining training examples using the B-reps of the dataset of B-reps and their representations. The representations may be modified. The conditioning signal of each training example representing said representation of the B-rep.

Notably, a plurality (e.g., seven) of representation may be associated with each of the B-rep, either by defining a plurality training sample starting from the same B-rep, or by defining conditioning signals, each comprising a plurality of different signals representing the same B-rep. The plurality of representation that may be associated with each of the B-rep may also be modified, as previously explained.

Obtaining a dataset of B-reps may also comprise obtaining a dataset of modeled objects (e.g., mechanical assemblies), and decomposing each modeled object into the single parts (e.g., decomposing a mechanical assembly into mechanical parts).

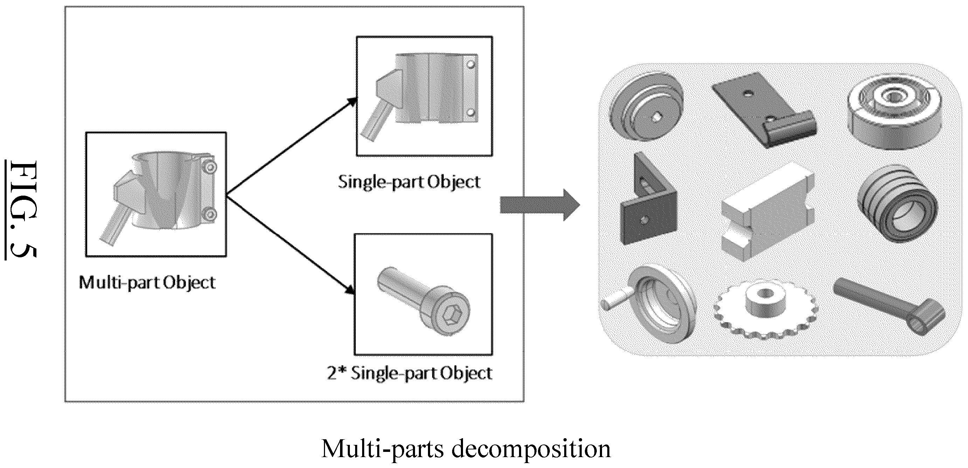

FIG. 5 illustrates the step of decomposing a modeled object.

The learning method may include, prior to the training of the neural networks, pre-processing the training dataset. Pre-processing a training dataset may include several steps, each of which may be executed training example-by-training example. That is, pre-processing a training dataset may be executed in parallel.

The pre-processing may include, for each B-rep comprised in the training dataset, determining a bounding box. A bounding box of a B-rep may be a box (e.g., a rectangular cuboid) of minimal size containing the B-rep, that is, with minimal width, height, and depth. A bounding box may be a standardized way of determining the position of a B-rep.

The pre-processing may include box uniformizing. Box uniformizing may comprise box uniformizing each of the B-rep comprised in the training dataset. Box uniformizing a B-rep may comprise modifying the B-rep in such a way that all the coordinates of all the components of the modified B-rep are between two fixed values, e.g., between the value "-0.5" and the value "0.5". Modifying a B-rep may comprise applying an affine function to all the coordinates of all the components of the B-rep. The components of a B-rep are the represented (e.g., in the associated coordinate system) points, curves, and surfaces of the B-rep. In particular, box uniformizing a B-rep may comprise modifying (e.g., by applying an affine function) the coordinates of all the points of the B-rep, each of the point being associated with a respective vertex of the B-rep. Box uniformizing may comprise (e.g., consist of) box centering and box normalizing.

The pre-processing may include box centering. Box centering may comprise box centering each of the B-rep comprised in the training dataset. Box centering a B-rep may comprise translating each of the component (e.g., the points corresponding to the vertices) of the B-rep in such a way that the origin (e.g., the origin of the cartesian coordinates used to represent the B-rep) is a center of the associated bounding box (i.e., the bounding box of the B-rep after translating each component of the B-rep). The center of a bounding box may be the point obtained as the average of the minimum and maximum coordinates of the bounding box in each of the three dimensions. Box centering a B-rep may, thus, comprise translating the B-rep by a vector, the vector being the opposite of the vector whose coordinates are the coordinate of the center of the relative bounding box. Therefore, box centering may comprise, for each B-rep comprised in the training example, subtracting the coordinates of the center of the relative bounding box from the coordinates of each of the components of the B-rep.

The pre-processing may comprise box normalizing. Box normalizing may comprise box normalizing each of the B-rep comprised in the training dataset. Box normalizing a B-rep may comprise normalizing the size of a diagonal of the associated B-rep. The diagonal may be the long diagonal of the associated B-rep. Specifically, box normalizing a B-rep may comprise modifying the coordinates of each component of the B-rep. The modifying of the coordinates may comprise multiplying each of the coordinates by a factor. The factor may be the inverse of the length of the long diagonal.

The pre-processing may also include loop removal. Loop removal may comprise removing loops from each of the B-reps comprised in the training dataset. Removing loops from a B-rep may comprise, for each edge of the B-rep, detecting whether said edge is a loop. A loop is an edge with a unique boundary vertex, that is, an edge which starting and end vertex coincide. Removing loops from a B-rep may comprise, whenever a loop is detected, adding an additional vertex separating the loop into two parts. Separating the loop into two parts may comprise adding two additional edges, both edges having as boundary the boundary of the loop and the additional vertex and removing the loop. Separating the loop into two parts may further comprise, for each loop removed, reparametrizing the curves associated with the loop. Reparametrizing the curves associated with the loop may comprise parametrizing the curves associated with the two additional edges. Parametrizing the curves may comprise parametrizing one of the curves with the first half of the parametrization of the loop, and the other with the second half. Therefore, the geometrical trace of the curve (i.e., the curve seen as a subset of the coordinate space) associated with the loop corresponds to the union of the geometrical traces of the curves associated with the two additional edges. Loop removal may be of importance because a generative function trained based on a dataset only comprising B-reps without loops may (e.g., with very high probability, or always) output B-reps without loops. This may be of importance as multiple CAD software do not support loops.

The pre-processing may also include sorting vertices, edges, faces, or a combination thereof. Each of the sorting vertices/edges/faces may include, for each B-rep comprised in the training dataset, sorting vertices/edges/faces of said B-rep. Sorting vertices/edges/faces of a B-rep may include defining an order among the vertices/edges/faces. An order (e.g., a total order) is a structure defining a first element, a last element, and for every other element a predecessor and a successor element. In particular, the pre-processing may comprise adding to each training sample additional information, the additional information being an order on the vertices, edges, faces, or combination thereof. The order may be of importance for the learning method, as it gives a unique and determined way of expressing the elements in a sequence or list.

Sorting vertices of a B-rep may comprise obtaining an order on the vertices of the B-rep. The order on the vertices may be coordinate-by-coordinate. Herein, by coordinate of a vertex it is meant the coordinates of the associated point. The order on the vertices may order the vertices from lowest to highest by z-coordinates. Whenever vertices have the same value of z-coordinate, the order may order the vertices from the lowest to the highest $y$-coordinate, and then similarly the order may order the vertices from the lowest to the highest x-coordinate.

Sorting edges of a B-rep may comprise obtaining an order on the edges of the B-rep. The order on the edges may, e.g., be induced from an order on the vertices. The order on the vertices may be the previously described order. For example, the B-rep may be without loops. Therefore, each edge of the B-rep may have two vertices, and each edge may have a first boundary vertex and a second boundary vertex, the first and second boundary vertices being distinct and the first boundary vertex being lower in the order on the vertices than the second. The order on the edges may order from an edge with a lowest (with respect to the order on the vertices) first boundary vertex to an edge with a highest first boundary vertex. Whenever two edges have a same first boundary vertex, the order may order the two edges with respect to the second boundary vertex. Whenever two edges have a same couple of boundary vertices, the order may choose a first edge by any method, e.g., depending on the order in which the edges appear in the source file, or randomly.

Sorting faces of a B-rep may comprise obtaining an order on the faces of the B-rep. The order on the faces may, e.g., be induced from an order on the edges. The order on the edges may be the previously described order. Each face of the B-rep has one or more boundary edges (e.g., at least 2). Sorting the faces may comprise, for each face, ordering the boundary edges (with respect to the order on the edges). Therefore, each face may have a first boundary edge (the lowest with respect to the order on the edges), a second boundary edge, etc. The order on the faces may order from a face with a lowest (with respect to the order on the edges) first boundary edge to a face with a highest first boundary edge. Whenever two faces have a same first boundary edge, the order may order the two faces with respect to the second boundary vertex. If two faces have a same first and a second boundary edge, the third is considered. Whenever two faces have the same boundary, the order may choose a first face by any method, e.g., depending on the order in which the faces appear in the source file, or randomly.

The pre-processing may also comprise a step of quantizing. A step of quantizing may comprise converting a real value to an integer (quantized) value. A step of quantizing may comprise quantizing the vertices of each of the B-reps comprised in the training dataset. Quantizing the vertices of a B-rep may comprise obtaining a strictly positive natural number *bits,* the number being a maximal number of bits determining the size of the quantization (e.g., *bits* = 8). Specifically, quantizing the vertices of a B-rep may comprise, quantizing each coordinate of each point associated with the respective vertex of the B-rep. Quantizing a coordinate may comprise (e.g., consist of) a process of converting the value of the coordinate of the associated point into discrete (e.g., integer) values. Quantizing a coordinate may comprise converting the value of the coordinate to an integer between 0 and $2^{bits}$ - 1. For example, quantizing a coordinate may comprise using the formula

$$ v_q = (v - r_{min}) \times \frac{2^{bits}-1}{r_{max}-r_{min}} $$

where $r_{min}$ and $r_{max}$ depend on the normalization of the bounding box. For example, $r_{min}$ and $r_{max}$ may be the minimal and maximal value of the coordinate of the points of the bounding box. For example, $r_{min}$ = -0.5 and $r_{max}$ = 0.5. Quantizing a coordinate may also comprise rounding the obtained value (e.g., with the above formula) to the nearest integer. The step of quantizing and/or quantizing the vertices of a B-rep may comprise using the same formula (e.g., the above given formula) to all the coordinates of all the points.

The pre-processing may also comprise a step of extraction. The step of extraction may comprise a step of extraction for each of the B-reps comprised in the training dataset. The step of extraction for a B-rep may comprise a step of extracting vertices, extracting topological edges, extracting geometrical edges (or, equivalently, curves), extracting topological faces, and extracting geometrical faces (or, equivalently, surfaces). The step of extraction for a B-rep may create, for each topological or geometrical element, a vector, the vector being directly usable by the neural network. The step of extraction may comprise encoding each of the topological and/or geometrical elements of the B-rep. A step of extraction may comprise quantizing values. The step of extraction may create (e.g., exclusively) vectors that are integer valued. The original vectors may be float-point vectors, however after normalization and quantization, each of the vectors may be integer valued, e.g., with values ranging from 0 to 255. The vectors may also comprise special symbols, such as *eos* (e.g., the special symbols may also be associated with integer values). The symbol *eos* may signify the "end of the sequence" and may be used by the neural network to identify that a sequence of elements is ended. The step of extraction may be of importance, as the step translates the various elements in information directly usable in the training process.

The step of extraction for a B-rep may comprise extracting the vertices of the B-rep. Extracting the vertices of the B-rep may comprise creating a vertex-vector. The vertex-vector may comprise data about the vertices of the B-rep and may be directly usable by the neural network. The vertex-vector may comprise data about each of the vertices of the B-rep and the data may be sequential with respect to an order of the vertices (e.g., the above defined order). The vertex-vector may comprise the values of the coordinates of each of the vertices of the B-rep. The values of the coordinates may be quantized, e.g., with the above defined process of quantization. The sequence may also comprise the symbol $eos$. In implementations, the vertices may be $v_1 = (x_1, y_1, z_1), ..., v_n = (x_n, y_n, z_n)$, wherein the coordinates $x_i, y_i$ and $z_i$ may be already quantized. Extracting may create the following vertex-vector $V^{seq} = \{x_1, y_1, z_1, ..., x_n, y_n, z_n, eos\}$.

The step of extraction for a B-rep may comprise extracting the topological edges of the B-rep. Extracting the topological edges of the B-rep may comprise creating a topological edge-vector. The topological edge-vector may comprise data about the topological edges of the B-rep and may be directly usable by the neural network. The topological edge-vector may comprise data about each of the topological edges of the B-rep and the data may be sequential with respect to an order of the edges (e.g., the above defined order). The topological edge-vector may consist of a sequence of vertices. The vertices may be the boundary vertices of the edges. The edge-vector may comprise the symbol $eos$. In implementations, the edge-vector may be $E^{seq} = \{v_1, v_2, ..., v_{2n-1}, v_{2n}, eos\}$, where the symbols $v_i$ may be associated with the vertices, the couple $\{v_{2i-1}, v_{2i}\}$ being a couple of vertices that consists in the boundary of the i-th edge. The number n may be the number of edges. The symbols $v_i$ may correspond to integers, corresponding to the order of the vertices, e.g., the first vertex in the order may be given the value "1", the second the value "2", etc.

The step of extraction for a B-rep may comprise extracting the geometrical edges of the B-rep. Extracting the geometrical edges of the B-rep may comprise creating a geometrical edge-vector. The geometrical edge-vector may comprise data about the geometrical edges of the B-rep and may be directly usable by the neural network. The geometrical edge-vector may comprise data about each of the geometrical edges of the B-rep and the data may be sequential with respect to an order of the edges (e.g., the above defined order). Prior to extracting the geometrical edges of a B-rep, the pre-processing may comprise obtaining a list of possible geometries for the edges. For example, the list may comprise any combination of the geometries of lines, arcs, B-splines, and/or NURBSs. Each of the possible geometries may be identified by an index (e.g., an integer). Prior to extracting geometrical edges, the pre-processing may also comprise obtaining a bound on the number of parameters influencing each of the geometries. For example, a line-geometry may not be influenced by any parameter, whereas the arc-geometry may be influenced by three parameters, the coordinates of a third point. B-splines and NURBS curves may be influenced by many different parameters, that may comprise control points, weight, and/or knot points. Obtaining a list of possible geometries and/or a bound may comprise obtaining the list of possible geometries and/or the bound from a user and/or automatically determining the list of possible geometries and/or bound on the base of the training dataset. The geometrical edge-vector may therefore comprise for each edge an identification of the geometry (e.g., a type of the geometry), followed by the parameters characterizing said geometry. The geometrical edge-vector may comprise the identification of the geometry in the same order as the topological edge-vector. In implementations, a bound of parameters may be denoted by $K$ and the geometrical edge-vector may be $GE^{seq} = \{t_1, p_{1,1}, ..., p_{1,K}, ..., t_n, p_{n,1}, ..., p_{n,K}\}$ where $t_i$ may be the type of geometry of the i-th edge (e.g., with respect to the above-defined order). For example, the type of geometry may be one of the above list, that is line, arc, B-spline, or NURB. For example, $t_i$ may be an index (e.g., an integer) corresponding to one of the above geometries. The symbols $p_{i,j}$ may indicate the parameters of the geometry. Specifically, $p_{i,j}$ may be a parameter influencing the type of geometry $t_i$ of the $i$-th edge. For example, the parameter may be a weight, a knot point, or a coordinate of a control point. In implementations, the values $p_{i,j}$ may be quantized values (e.g., with the above given formula). In implementations a special symbol (e.g., "-1") may be used to identify that the parameter is not required by the given geometry. For example, $t_1$ may identify a line-geometry, and, as no parameters may be required, in the implementation $p_{1,i}$ may be -1 for every $i$. For example, $t_2$ may be an arc-geometry, $p_{2,1}$, $p_{2,2}$, $p_{2,3}$ may be the (e.g., quantized) coordinates of the parameter point and $p_{2,i}$ may be -1 for all other $i$.

The step of extraction for a B-rep may comprise extracting the topological faces of the B-rep. Extracting the topological faces of the B-rep may comprise creating a topological face-vector. The topological face-vector may comprise data about the topological faces of the B-rep and may be directly usable by the neural network. The topological face-vector may comprise data about each of the topological faces of the B-rep and the data may be sequential with respect to an order of the faces (e.g., the above defined order). The topological face-vector may consist of a sequence of edges. The edges may be the boundary edges of the face and may be presented in an order, e.g., the above defined order. The topological face-vector may comprise the symbol $nf$, "new face", identifying the start of a new face. The symbol $nf$ may express the separation between faces. The topological face-vector may comprise the symbol $eos$. In implementations, the topological face-vector may be $F^{seq} = \{e_{1,1}, ..., e_{1,a_1}, nf, ..., e_{m,a_m}, eos\}$, where the symbols $e_{i,j}$ are associated with the edges, the $j$-th edge of the boundary of the $i$-th face (e.g., with respect to the above order). The symbols $e_{i,j}$ may be integers, corresponding to the order of the edges, e.g., the first edge in the order may be given the value "1", the second the value "2", etc.

The step of extraction for a B-rep may comprise extracting the geometrical faces of the B-rep. Extracting the geometrical faces of the B-rep may comprise creating a geometrical face-vector. The geometrical face-vector may comprise data about the geometrical faces of the B-rep and may be directly usable by the neural network. The geometrical face-vector may comprise data about each of the geometrical faces of the B-rep and the data may be sequential with respect to an order of the faces (e.g., the above defined order). Prior to extracting the geometrical faces of a B-rep, the pre-processing may comprise obtaining a list of possible geometries for the faces. For example, the list may comprise any combination of the geometries of planes, cylinders, tori, cones, spheres, and/or NURBSs. Each of the possible geometries may be identified by an index (e.g., an integer). Prior to extracting geometrical faces, the pre-processing may also comprise obtaining a bound on the number of parameters influencing each of the geometries. For example, a plane-geometry may not be influenced by any parameter, whereas NURBS surfaces may be influenced by many different parameters, which may comprise control points, weight, and/or knot points. Obtaining a list of possible geometries and/or a bound may comprise obtaining the list of possible geometries and/or the bound from a user and/or automatically determining the list of possible geometries and/or bound on the base of the training dataset. The geometrical face-vector may therefore comprise for each face an identification of the geometry (e.g., a type of the geometry), followed by the parameters characterizing said geometry. The geometrical face-vector may comprise the identification of the geometry in the same order as the topological face-vector. In implementations, a bound of parameters may be denoted by $K$ and the geometrical face-vector may be $GF^{seq} = \{t_1, p_{1,1}, ..., p_{1,K}, ..., t_n, p_{n,1}, ..., p_{n,K}\}$ where $t_i$ may be the type of geometry of the $i$-th face (e.g., with respect to the above-defined order). For example, the type of geometry may be one of the above list, that is, plane, cylinder, torus, cone, sphere, or NURBS. For example, $t_i$ may be an index (e.g., an integer) corresponding to one of the above geometries. The symbols $p_{i,j}$ may indicate the parameters of the geometry. Specifically, $p_{i,j}$ may be a parameter influencing the type of geometry $t_i$ of the $i$-th face. For example, each parameter may be a weight, a knot point, or a coordinate of a control point. In implementations, the values $p_{i,j}$ may be quantized values (e.g., with the above given formula). In implementations a special symbol (e.g., "-1") may be used to identify that the parameter may not be required by the given geometry. For example, $t_1$ may identify a plane-geometry, and, as no parameters may be required, $p_{1,i}$ may be -1 for every $i$.

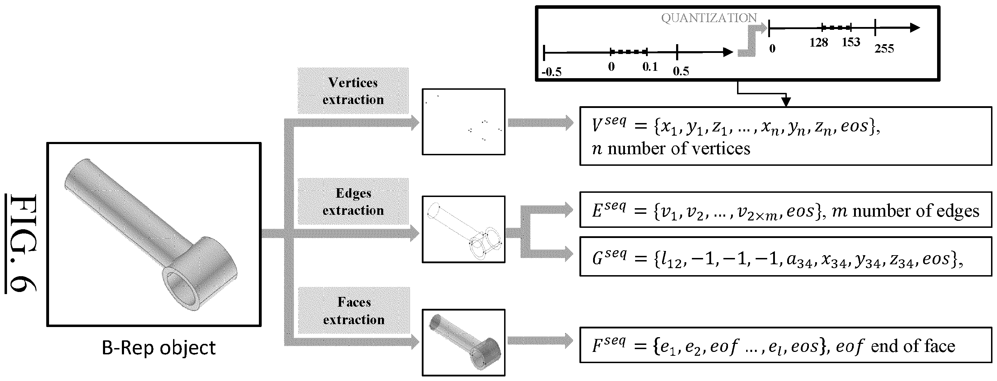

FIG. 6 illustrates an example of the extraction process, comprising quantization, vertex-extraction, topological edge extraction, geometrical edge extraction, and topological face-extraction.

The generative function comprises a vertex network, an edge neural network, and a face neural network. The edge neural network comprises an edge topology neural network and an edge geometry neural network. The face neural network comprises a face topology neural network and a face geometry neural network. Therefore, the generative function comprises at least five neural networks, each of which is designed to learn and generate the different topological and geometrical entities of a B-rep. In implementations, one or more of the at least five neural networks may be combined together.

In implementations, given a conditioning signal representing a geometry $O$, the generative function may learn the probability distribution $p(B|O)$. That is, the probability that the conditioning signal is associated with a B-rep $B$. This probability may be rewritten as a product of probabilities, with respect to a set of vertices V, edges E (both topological and geometrical), and faces F (both topological and geometrical), as follows:

$$p(B|O) = p(V,E,F|O) = p(V|O) \times p(E|V,O) \times p(F|E,V,O).$$

In implementations, the vertex network may learn the probability distribution $p(V|O)$, that is the probability that the conditioning signal $O$ is associated with the set of vertices $V$. The edge neural network may learn the probability distribution $p(E|V,O)$, that is that the conditioning signal $O$ and the set of vertices $V$ are associated with the set of edges (both topological and geometrical) E. The face neural network may learn the probability distribution $p(F|E,V,O)$ that is that the conditioning signal $O$, the set of vertices $V$, and the set of edges (both topological and geometrical) $E$ are associated with the set of faces (both topological and geometrical) $F$.

In implementations, applying the generative function to generate a B-rep based on the conditioning signal of the method of use, may comprise applying the trained vertex neural network to the conditioning signal, thereby obtaining a set of vertices. Afterwards, applying the generative function may comprise applying the edge neural network to the conditioning signal and the obtained set of vertices, thereby obtaining a set of edges (both topological and geometrical). Afterwards, applying the generative function may comprise applying the face neural network to the conditioning signal, the obtained set of vertices, and the obtained set of edges (both topological and geometrical), thereby obtaining a set of faces (both topological and geometrical). The generated B-rep may be based on the obtained vertices, edges and faces. In implementations, applying the edge neural network and the face neural network may comprise first applying the relative topological neural network and then the relative geometrical neural network.

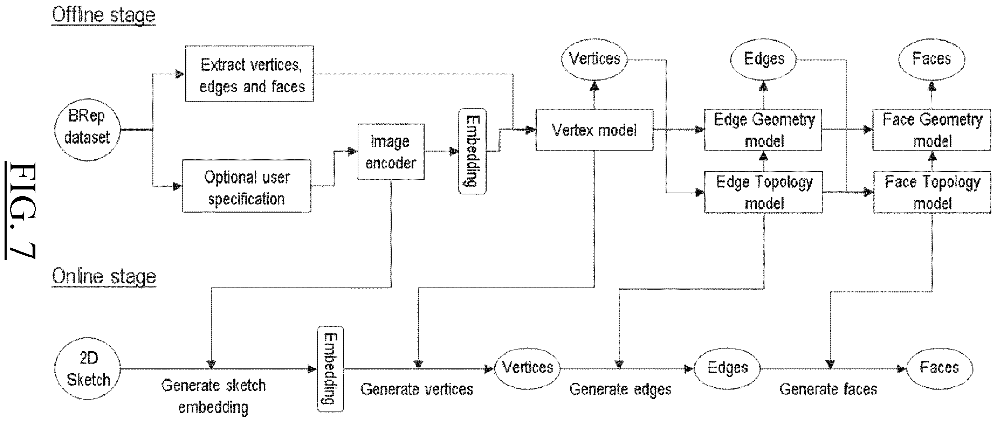

FIG. 7 illustrates the different steps of the learning method and the method of use. In particular, the step of extracting vertices, edges and faces, and the five connected neural networks.

One or more of the neural networks (comprised in the generative function) may comprise a probabilistic output. A neural network comprising a probabilistic output may be referred to as a probabilistic neural network. That is, one or more of the neural networks (comprised in the generative function) may be probabilistic neural networks. Each probabilistic neural network may be trained to, given an input signal (e.g., comprising a conditioning signal representing a geometry), give several outputs, each output being associated with a probability. The probability may be a confidence score and may indicate the confidence that the neural network has with the given output. For example, a probabilistic neural network may comprise a soft-max function, the soft-max function enabling the probabilistic output.

The generative function may include, for each probabilistic neural network comprised in the generative function, a method for determining an output from the probabilistic output, the determined output being the output used for generating the B-rep. For example, the generative function may comprise greedy sampling. That is, the generative function may select the most probable output for at least one of the probabilistic neural networks. Additionally or alternatively, the generative function may select randomly an output from the probabilistic output for at least one of the probabilistic neural networks. Randomly herein means that the output is chosen according to the probability given by the probabilistic output. Additionally or alternatively, the generative function may select randomly an output from a selection of the probabilistic output for at least one of the probabilistic neural networks. The selection may be any subset of the output, e.g., the three, or five, most probable outputs. Randomly herein means that the output is chosen according to the normalized probability given by the selection of the probabilistic output.

The learning method comprises training the generative function based on the training dataset. Training the generative function comprises training each of the at least five different neural networks. The training may be done separately, that is, the training of each of the neural networks may be independent from the training of the others. For example, the training may be executed in parallel.

Notably, training the generative function based on the training dataset may comprise, at each batch and/or epoch, for each training sample comprising a conditioning signal comprising a plurality (e.g., seven) of signals representing a same geometry, selecting one of the signals to be used in the training. Selecting may be done in any way known in the art, e.g., randomly selecting with respect to a uniform probability.

One or more of the neural networks comprised in the generative function may comprise a deep neural network (DNN). DNNs are powerful models of neural networks that are biologically inspired and that learn from observational data. More specifically, DNNs are focused on end-to-end learning based on raw data. In other words, they move away from feature engineering to the maximum extent possible, by accomplishing an end-to-end optimization starting with raw features and ending in labels.

One or more of the neural networks comprised in the generative function may comprise a generative model. Generative models are a type of deep neural networks, which are trained on large datasets to learn the underlying distribution of the training data. By sampling from the learned distribution, such models can produce new data that possess characteristics from the ones in the training dataset. For example, one or more of the neural networks comprised in the generative function may be a GAN (Generative Adversarial Network) or a VAE (Variational Autoencoder). One or more of the neural networks comprised in the generative function may comprise a transformer. Transformers (discussed in reference Ashish Vaswani, Noam Shazeer, Niki Parmar, Jakob Uszkoreit, Llion Jones, Aidan N. Gomez, Ł ukasz Kaiser, and Illia Polosukhin. "Attention is all you need", In I. Guyon, U. Von Luxburg, S. Bengio, H. Wallach, R. Fergus, S. Vishwanathan, and R. Garnett, editors, Advances in Neural Information Processing Systems, volume 30, Curran Associates, Inc., 2017, which is incorporated herein by reference) are a type of deep neural networks architecture, which possess remarkable ability to perceive relationships among elements within an input sequence. Thanks to a mechanism called self-attention, transformers make it possible for the model to learn the relevance of each element to the others, and to weigh the contextual information appropriately. Transformer modules take as input a sequence and output a new vector representation of the input data, in which relations within the input sequence are emphasized. Transformers may comprise, or consist of, a transformer encoder and/or a transformer decoder.

One or more of the neural networks comprised in the generative function may comprise a pointer network. Pointer networks (discussed in reference Oriol Vinyals, Meire Fortunato, Navdeep Jaitly. "Pointer Networks", In I. C. Cortes and N. Lawrence and D. Lee and M. Sugiyama and R. Garnett, editors, Advances in Neural Information Processing Systems, volume 28, Curran Associates, Inc., 2015, which is incorporated herein by reference) are DNNs designed to generate as output sequences by selecting elements from an input sequence. Pointer networks, like transformers, use attention mechanism. Unlike conventional models that generate outputs from a fixed vocabulary, Pointer Networks dynamically reference input positions, allowing for variable-length and input-dependent outputs. Additionally or alternatively, one or more of the neural networks comprised in the generative function may comprise a module designed to output the scalar product between the output of a transformer module and the an embedding module (e.g., embeddings of the edges, or faces), the scalar product being used to select one element (e.g., an edge, or a face).

It is understood that in implementations the neural networks comprised in the generative function may comprise (e.g., consists of) different neural network structure and/or functions, the neural network structures and/or functions being related to each other. For example, in implementations, the neural network comprised in the generative function may comprise one or more linear models, embeddings, encoders, activation functions, transformer encoders or decoders, pointer networks, softmax functions, any of the previously discussed neural network structure, or any combination thereof. FIG.s 8-15 illustrate different implementations of the different neural networks that may be comprised in the generative function.

One or more of the neural networks comprised in the generative function may be autoregressive. The one or more autoregressive neural networks may predict (i.e., generate) elements (e.g., tokens, entries) one at a time, each prediction using all the previous predictions and the conditioning signal. In other words, the one or more autoregressive neural networks may be trained to generate output sequences by generating each element sequentially, the generating of each element (e.g., token) being conditioned to the prediction of previously generated elements and the conditioning signal. The one or more autoregressive neural networks may comprise generating probabilistic outputs for each of the elements in the sequence and may comprise any of the previously discussed methods for determining an output out of the probabilistic output. An autoregressive neural network may be advantageous by allowing the network to maintain contextual continuity. Autoregressive neural networks may also effectively learn and utilize the dependencies and correlations inherent in the data.

Training an autoregressive neural network comprised in the generative function may comprise mask training. Mask training may comprise obscuring part of the input data during the training process. Specifically, training the autoregressive neural network with mask training may comprise, at each step of the training, selecting part of the training data and only using that part of the training data. For example, training the autoregressive neural network may comprise training the network to generate a next element of the list, without the knowledge of any of the future elements. Mask training compels the neural network to predict the next element based on the previous elements and the conditioning signal, thereby fostering the learning of intricate sequential dependencies and enhancing the model's ability to generate coherent and contextually accurate outputs. This approach not only improves the generative performance of the model but also contributes to its generalization capabilities (i.e., generating data) across diverse data scenarios.

Training an autoregressive neural network comprised in the generative function may comprise teacher forcing. Training the autoregressive neural network with teacher forcing may comprise training the neural network to predict the next element of the sequence based on the ground truth of the previous elements. Ground truth of the previous elements hereby means the elements as they are in the training sample. That is training with teacher forcing may not use the previously predicted elements to predict a next element. Training with teacher forcing offers several advantages, including parallelization, which leads to fast convergence. In fact, each prediction of a given element based on the ground truth of the previous elements is independent from the other predictions. Therefore, the training process may be parallelized. This is in contrast to the training technique where predicting a given token is based on the previous predictions. Importantly, this capacity for parallel computation enables GPU rapid processing. Furthermore, it helps prevent error accumulation, as any wrong predicted token is corrected to reconstruct the remaining sequence.

Additionally or alternatively, one or more of the neural networks comprised in the generative function may be non-autoregressive. The one or more non-autoregressive neural networks may predict (i.e., generate) elements (e.g., tokens) all at one time based on the conditioning signal. In other words, the one or more non-autoregressive neural networks may be trained to generate output sequences directly, only using the conditioning signal. The one or more non-autoregressive neural networks may comprise generating probabilistic outputs for the sequence and may comprise any of the previously discussed methods for determining an output out of the probabilistic output. Non-autoregressive neural networks produce all the elements of the output simultaneously or in parallel. This parallel generation approach significantly reduces the time complexity and computational resources required for data generation, enabling faster inference and scalability to larger datasets. Moreover, non-autoregressive neural networks may be advantageous in that they prevent the accumulation of errors, by predicting all the elements at the same time and not basing future predictions on previous predictions.

Training the generative function based on the training dataset may comprise training at least one of the one or more neural networks comprised in the generative function using a loss function. For example, training the at least one of the one or more neural networks may comprise maximizing the log-likelihood of the training data. The log-likelihood function is the logarithm of the likelihood function. For example, the at least one of the one or more neural networks may comprise generating a probabilistic output and the likelihood function may express a conditional probability of giving the right answer (i.e., as expressed by the training sample) given the input conditioning signal (i.e., as given by the training sample). The likelihood function may also comprise averaging over the samples used in a batch while training. Maximizing the log-likelihood may comprise minimizing an associated cross-entropy loss function. By maximizing the log-likelihood and/or minimizing the associated cross-entropy loss function, the parameters of the neural network may be optimized effectively, enhancing the model's ability to generate data that closely resembles the training dataset.

The generative function comprises a vertex neural network configured to generate B-rep vertices respecting the conditioning signal. In implementations, the vertex neural network may be a probabilistic neural network, e.g., comprise a softmax function. In implementations, the vertex neural network may comprise, e.g., a DNN, a generative model, a transformer, a transformer encoder and/or decoder, or a combination thereof. In implementations, a vertex neural network may be trained using cross-entropy loss.

In implementations, training the vertex neural network may comprise one or more of the above-described pre-processing methods. In particular, in implementations, training the vertex neural network may comprise extracting vertices and/or sorting vertices. Specifically, in implementations, training the vertex neural network may comprise, for each B-rep comprised in the training sample, obtaining a vertex-vector $V^{seq} = \{x_1, y_1, z_1, ..., x_n, y_n, z_n, eos\}$ as explained above. That is, the vertices may be $v_1 = (x_1, y_1, z_1), ..., v_n = (x_n, y_n, z_n)$, where the coordinates $x_i$, $y_i$, and $z_i$ may be already quantized. In implementations, the trained vertex neural network may generate vertex-vectors with similar form.

In implementations, given a conditioning signal representing a geometry $O$, the vertex neural network may learn the probability vector $p(V^{seq}|O)$, that is, the probability that the conditioning signal is associated with the vertex-vector $V^{seq}$.

In implementations, the vertex neural network may be autoregressive. In implementations, the autoregressive vertex neural network may learn to generate the sequence $V^{seq}$ element by element, each generation using the previous generation. That is, in implementations, the above-defined probability vector may be decomposed as follows:

$$p(V^{seq}|O; \theta_V) = \prod_{i=1}^{|V^{seq}|} p(v_i|v_1, v_2, ..., v_{i-1}, O; \theta_V)$$

where $\theta_V$ are the learnable parameters. In other words, the goal of the autoregressive model may be to predict a next vertex $v_i$ based on previous tokens $v_{<i}$.

In implementations, the autoregressive vertex neural network may comprise embeddings (e.g., encodings, vertex encodings). Embeddings may comprise one or more learnable matrices (i.e., matrices with learnable parameters) to encode the relationship among the entries of the vertex-vector $V^{seq}$. Embeddings may comprise obtaining an embedding dimension, denoted $d$. In implementations, embeddings may further comprise combining and/or concatenating on or more steps (e.g., one or more learnable matrices) into a single embedding (e.g., a single matrix).

In implementations, embeddings may comprise coordinate encoding. Coordinate encoding may comprise a learnable matrix $W_{coor}$ of shape $[3, d]$. The coordinate encoding may indicate whether a token (e.g., an entry, an element) is a first, second, or third coordinate.

In implementations, embeddings may comprise position encoding. Position encoding may comprise a learnable matrix $W_{pos}$ of shape $[|V|_{max}, d]$, where $|V|_{max}$ is the maximum number of vertices. The position encoding $W_{pos}$ may indicate to which vertex the token (e.g., element, entry) belongs to.

In implementations, embeddings may comprise value encoding. Value encoding may comprise a learnable matrix $W_{val}$ of shape $[2^{bits} + 1, d]$, where $bits$ is the number of bits used in quantization. The value encoding $W_{val}$ may provide an embedding for each level of the uniform quantization. In the learnable matrix $W_{val}$ the first $2^{bits}$ rows may be used to encode vertex coordinate values, and the last row may be used to encode the "end of sequence" $eos$ token.

In implementations, the autoregressive vertex neural network may comprise mask training and/or teacher forcing. In implementations, the autoregressive vertex neural network may learn, given an input sequence, $V^{in} = \{st, v_1, v_2, ... v_n\}$ and a conditioning signal, to generate the same sequence shifted to the right $V^{out} = \{v_1, v_2, ..., v_n, eos\}$. Herein, $st$ may represent the "starting token" and $eos$ may represent the "end of sequence" token. In implementations, the token $eos$ may be used to stop generating vertices.

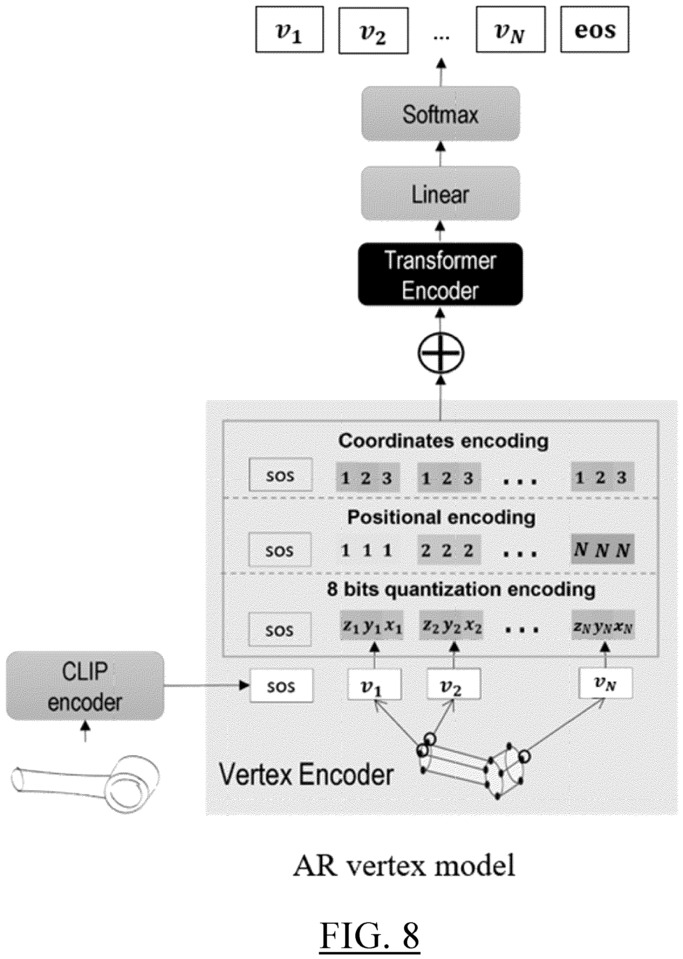

FIG. 8 illustrates an implementation of the autoregressive vertex neural network, comprising vertex encoder, embeddings, a transformer encoder model, a linear model, and a softmax step.

Alternatively, in implementations, the vertex neural network may be non-autoregressive. In implementations, the non-autoregressive vertex neural network may learn to generate the sequence $V^{seq}$ all at a same time. In implementations, the above-defined probability vector may be decomposed as follows:

$$p(V^{seq}|O; \theta_V) = \prod_{i=1}^{|V^{seq}|} p(v_i|O; \theta_V)$$

where $\theta_V$ are the learnable parameters. In other words, the goal of the non-autoregressive model is to predict the sequence $v_{1 \le i \le |V^{seq}|}$ at the same time.

In implementation, training the non-autoregressive vertex neural network may learn, given the "starting token" $st$ and a conditioning signal, to reconstruct the sequence $V^{out} = \{v_1, v_2, ..., v_n, eos\}$. In implementations, training a non-autoregressive neural network may comprise a cross-entropy loss function. For example, in implementations, the training may be done by averaging the cross-entropy loss function over a sequence prediction, with each predicted coordinate separately being compared to the ground-truth (by cross-entropy).

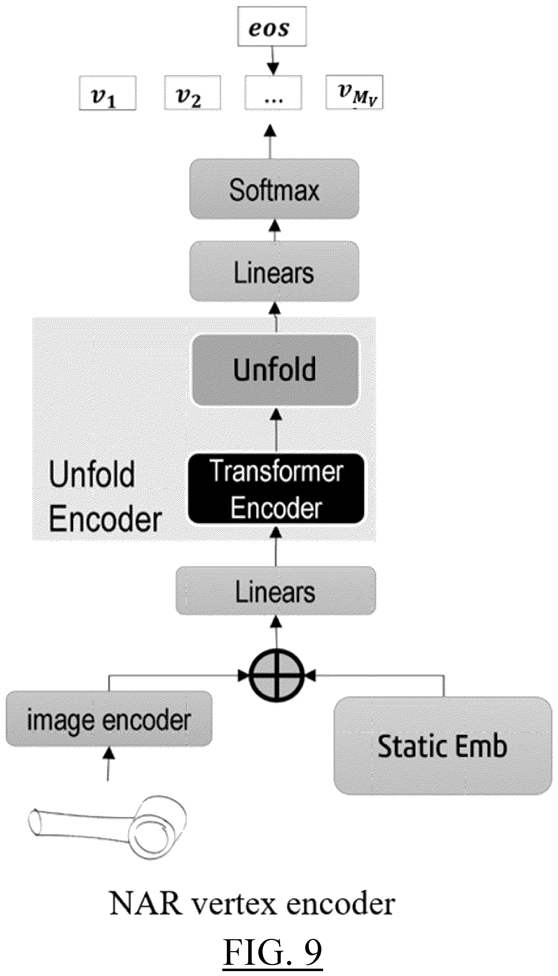

FIG. 9 illustrates an implementation of the non-autoregressive vertex neural network, comprising image encoder, embeddings, a transformer encoder model, a linear model, and a softmax step.

In implementations, the vertex neural network may be trained to, given a conditioning signal representing a geometry, generate a sequence of vertices of a B-rep representing the geometry. In particular, the method of use may generate said vertices given said conditioning signal.

The generative function comprises an edge neural network configured to, given generated vertices (e.g., generated with a vertex neural network), and a conditioning signal, generate B-rep edges respecting the conditioning signal. The edge neural network may learn the distribution of edges conditioned on the vertices and the conditioning signal representing a geometry.

The edge neural network comprises an edge topology neural network configured for generating edge connections between the generated vertices, given the generated vertices and a conditioning signal.

In implementations, the edge topology neural network may be a probabilistic neural network. In implementations, the edge topology neural network may comprise, e.g., a DNN, a generative model, a transformer, a transformer encoder and/or decoder, a pointer network, or a combination thereof. In implementations, the edge topology neural network may be trained using cross-entropy loss.

In implementations, training the edge topology neural network may comprise one or more of the above-described pre-processing methods. In particular, in implementations, training the edge topology neural network may comprise extracting topological edges, and/or sorting edges and/or vertices. Specifically, in implementations, training the edge topology neural network may comprise, for each B-rep comprised in the training sample, obtaining a topological edge-vector $E^{seq} =$

$\{v_1, v_2, ..., v_{2n-1}, v_{2n}, eos\}$, as explained above. That is, each of the couple $\{v_{2i-1}, v_{2i}\}$ may be a couple of vertices that are the boundary of an edge. In implementations, the symbols $v_i$ may correspond to integers, corresponding to the order of the vertices. In implementations, the trained edge topology neural network may generate topological edge-vectors with similar form. In implementations, the symbol "end of sequence" $eos$ may be used to express the end of the sequence of edges.

In implementations, given a conditioning signal representing a geometry $O$ and a vertex-vector $V^{seq}$, the edge topology neural network may learn the probability vector $p(E^{seq}|V^{seq}, O)$, that is, the probability that the conditioning signal and the vertex-vector are associated with the topological edge-vector $E^{seq}$.

In implementations, the edge topology neural network may be autoregressive. In implementations, the autoregressive edge topology neural network may learn to generate the sequence $E^{seq}$ element by element, each generation using the previous generation. That is, in implementations, the above-defined probability vector may be decomposed as follows:

$$p(E^{seq}|V^{seq}, O; \theta_E) = \prod_{i=1}^{|E^{seq}|} p(v_i|v_1, v_2, \ldots, v_{i-1}, V^{seq}, O; \theta_E)$$

where $\theta_E$ are the learnable parameters. The probability vector may be associated with a distribution defined over vertex indexes. In other words, the goal of the autoregressive edge topology neural network may be to predict a next vertex index $v_i$, based on previous vertex indices $v_{<i}$, the sequence of vertices $V^{seq}$ and a conditioning signal $O$.

In implementations, the autoregressive edge topology neural network may comprise embeddings (e.g., encodings). Embeddings may comprise one or more learnable matrices (i.e., matrices with learnable parameters). Embedding may comprise obtaining an embedding dimension $d$. In implementations, embeddings may further comprise combining and/or concatenating one or more steps (e.g., one or more learnable matrices) into a single embedding (e.g., a single matrix).

In implementations, embeddings may comprise any of the previously defined embeddings for the vertex neural network. In implementations, embeddings may comprise three types of value embeddings based on the three coordinates. The embeddings may comprise a vertex encoder. In implementations, embeddings may further comprise concatenating the three types of value embeddings into a single embedding for each vertex. In implementations, embeddings may further comprise applying a linear layer to project the concatenated embedding. In implementations, the symbol "end of sequence" $eos$ may be encoded with a learnable embedding. In implementations, embeddings may further comprise a transformer encoder, resulting in matrix $H_{vert}$ of shape $[|V| + 1, d]$ where $|V|$ represents the total number of vertices and $d$ represents the final embeddings dimension.

In implementations, the autoregressive edge topology neural network may comprise mask training and/or teacher forcing. In implementations, the autoregressive edge topology neural network may learn, given an input sequence $E^{in} = \{st, e_1, e_2, ..., e_n\}$, to generate the same sequence shifted to the right $E^{out} =$

$\{e_1, e_2, ..., e_n, eos\}$ (e.g., using a vertex-vector and a conditioning signal). Herein, $st$ may represent the "starting token" and $eos$ may represent the "end of sequence" token. In implementations, the token $eos$ may be used to stop generating edges (e.g., the boundary vertices representing edges).

In implementations, the autoregressive edge topology neural network may comprise obtaining the embeddings for the elements in the input sequence by gathering the embeddings $H_{vert}$ corresponding to the vertex indices and the symbol of "end of sequence" *eos.* In implementations, the autoregressive edge topology neural network may further comprise a positional embedding $W_{pos}$ indicating the position of each token $e_i$ in the sequence $E^{seq}$. Specifically, in implementations, the input sequence embedding may be obtained by

$$H(E^{in}) = \{H_{vert}[e_i] + W_{pos_i}\}.$$

where $W_{pos_i}$ corresponds to the positional embedding of token at the *i*-th position in the sequence of edges. In implementations, the matrix $W_{pos}$ may be a matrix of size $N * d$, where $N$ is the maximal size of the sequence of edges and $d$ the embedding dimension. The *i*-th row of the matrix $W_{pos}$ may correspond to a vector having as size the dimension of the model, and corresponding to the positional embedding at the *i*-th position.

In implementations, the edge topology neural network may comprise a masked transformer decoder processing any of the above-discussed embeddings. Implementations may further comprise a linear layer to output a pointer vector. Implementations may further comprise a pointer network, the pointer network being able to point to a sequence of vertices (e.g., indices of vertices) obtained as input. The pointer network may compute the dot-product between the pointer vector and the vertex index embeddings $H_{vert}$.

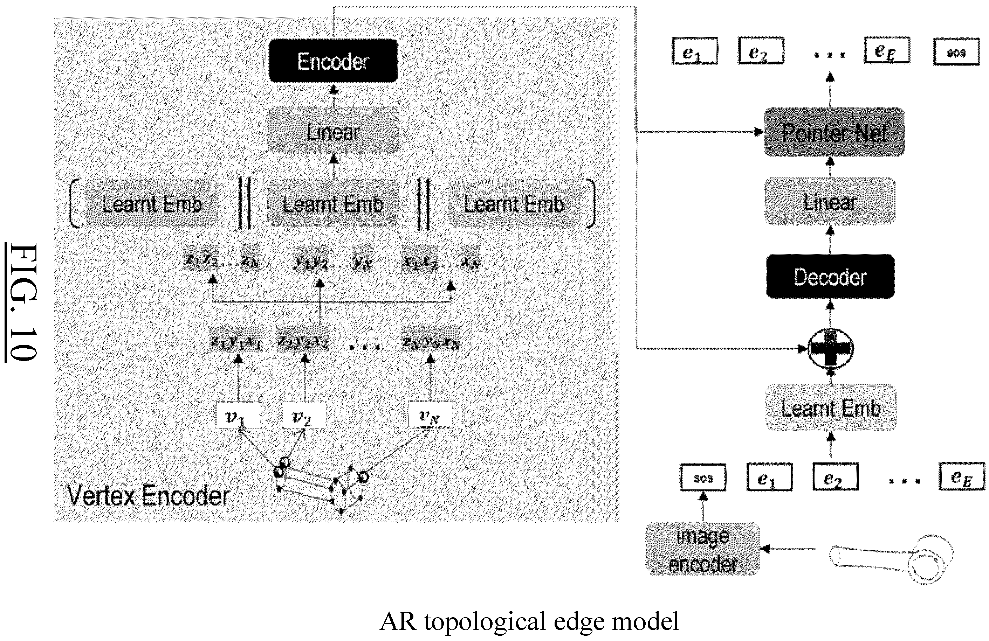

FIG. 10 illustrates an implementation of the autoregressive edge topology neural network, comprising image encoder, embeddings, a transformer encoder and decoder model, a linear model, a pointer network, and a softmax step.

Alternatively, in implementations, the edge topology neural network may be non-autoregressive. In implementations, the non-autoregressive edge topology neural network may learn to generate the sequence $E^{seq}$ all at a same time. In implementations, the above-defined probability vector may be decomposed as follows:

$$p(E^{seq}|V^{seq}, O; \theta_E) = \prod_{i=1}^{|E^{seq}|} p(e_i|V^{seq}, O; \theta_E)$$

where $\theta_E$ are the learnable parameters. In other words, the goal of the non-autoregressive edge topology neural network may be to predict $e_{1 \leq i \leq |E^{seq}|}$ at the same time given the sequence of vertices $V^{seq}$ and a conditioning signal $O$.

In implementations, the non-autoregressive edge topology neural network may comprise embeddings (e.g., a vertex encoder). In implementations, embeddings may comprise (e.g., consists of) the embeddings of the autoregressive edge topology neural network. In implementations, the non-autoregressive edge topology neural network may further comprise a transformer decoder and/or a pointer network. In implementations, the non-autoregressive edge topology neural network may predict a sequence $E^{out} = \{e_1, e_2, ..., e_n, eos\}$ given the "starting token" *st,* a vertex-vector, and a conditioning signal.

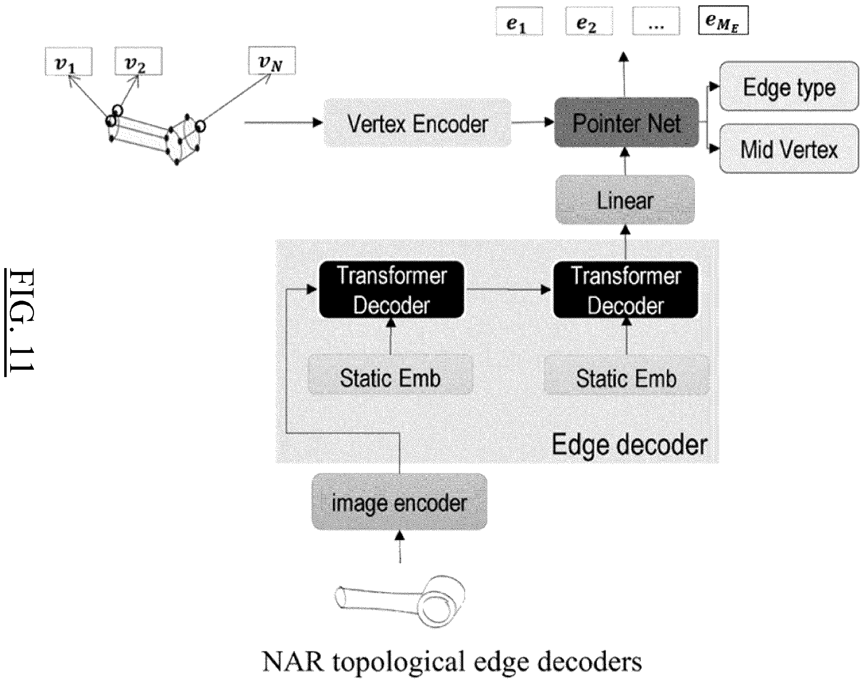

FIG. 11 illustrates an implementation of the autoregressive edge topology neural network, comprising image encoder, embeddings, a transformer decoders model, linear models, and a pointer network.

In implementations, the edge topology neural network may be trained to, given a vertex-vector (e.g., generated with a vertex neural network) and conditioning signal representing a geometry, generate a sequence of (topological) edges of a B-rep representing the geometry. In particular, the method of use may generate said edges given said conditioning signal (e.g., by using the generated vertex-vector).

The edge neural network further comprises an edge geometry neural network configured for determining geometries of the generated edge connections. In implementations, the edge geometry neural network may be a probabilistic neural network. In implementations, the edge geometry neural network may comprise, e.g., a DNN, a generative model, a transformer, or a combination thereof. In implementations, the edge geometry neural network may be trained using cross-entropy loss.

In implementations, training the edge geometry neural network may comprise one or more of the above-described pre-processing methods. In particular, in implementations, training the edge geometry neural network may comprise extracting the geometrical edges, and sorting edges and/or vertices. Specifically, in implementations, training the edge geometry neural network may comprise, for each B-rep comprised in the training sample, obtaining a geometrical edge-vector $GE^{seq} = \{g_1, ..., g_{(K+1) \times n}\}$, as explained above, where $n$ is the number of edges, $K$ is the number of parameters of each geometry type, and $g_i$ is either a geometry type (e.g., line, arc, B-spline, or NURBS) or a parameter influencing a geometry type (e.g., weight, knot point, or a coordinate of a control point). For example, $g_{1+i(K+1)}$ may be a geometry type for every $i$ and every other parameter may be a parameter influencing a geometry type. In implementations, $g_{1+i(K+1)}$ may be a geometry type influencing the *i*-th edge (e.g., with respect to an order on the edges) and $g_{1+i(K+1)+j}$ may be a parameter influencing the geometry type $g_{1+i(K+1)}$ for every $1 \le j \le K.$

In implementations, the edge geometry neural network may comprise embeddings and/or encodings, e.g., the embeddings and/or encodings defined in the implementations of the previously defined neural networks or variation thereof. The embeddings and/or encoding may further comprise quantizing parameters.

In implementations, the edge geometry neural network may use the pointer vectors generated by a pointer network layer (e.g., in the edge topology neural network). In implementations, the edge geometry neural network may comprise concatenating the vertex embedding corresponding to the end-points vertices of an edge. In implementations, the edge geometry neural network may further comprise a linear layer concatenated with a method for concatenating the vertex embedding to obtain an embedding for each edge.

In implementations, training the edge geometry neural network may comprise computing a loss (e.g., with a cross-entropy loss) and the tokens corresponding to non-required parameters by a given geometry may be discarded for the loss computation.

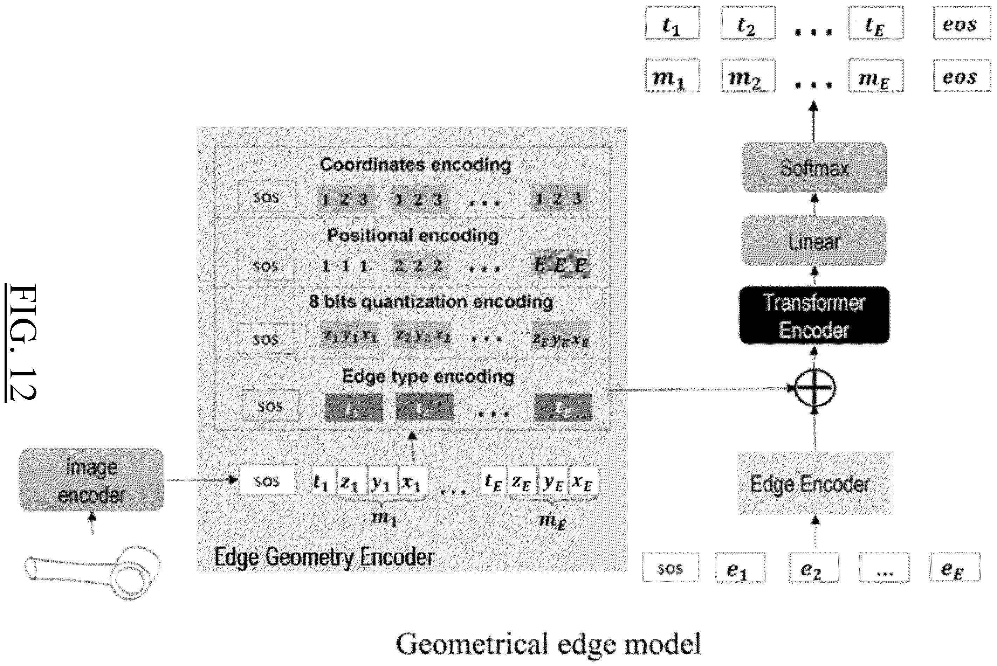

FIG. 12 illustrates an implementation of the edge geometry neural network, comprising vertex and/or edge encoder, an image encoder, a transformer encoder model, a linear model, and a softmax step.

In implementations, given a conditioning signal representing a geometry $O$ and a topological edge-vector $E^{seq}$, the edge geometry neural network may learn the probability vector $p\left(GE^{seq}|E^{seq}_{\le}, O\right)$, that is, the probability that the conditioning signal and the topological edge vector are associated with the geometrical edge-vector $GE^{seq}$.

In implementations, the edge geometry neural network may be autoregressive. In implementations, the autoregressive edge geometry neural network may learn to generate the sequence $GE^{seq}$ element by element, each generation using the previous generation. Each generation may consist of a geometry type, a geometry parameter for an associated edge, or a symbol, such as the "end of sequence" symbol. In implementations, the generation of the geometry types may follow an order on the edges and the geometry parameter may follow the associated geometry type. In implementations, the symbol $E^{seq}_{\le}$ may express that each prediction may be done on the base of the associated edge and all the previous edges (e.g., with respect the order). That is, in implementations, the above-defined probability vector may be decomposed as follows:

$$p(GE^{seq}|E_{\le}, O; \theta_{GE}) = \prod_{i=1}^{|GE^{seq}|} p(g_i|g_{<i}, e_{\le\left\lfloor\frac{i}{K+1}\right\rfloor}, O; \theta_{GE})$$

where $\theta_{GE}$ are learnable parameters of the network. In other words, the goal of the autoregressive edge geometry neural network is to predict a next geometry type or parameter $g_i$, based on the previous geometry types and/or parameters $g_{<i}$, the previous and current topological edges, and the conditioning signal $O$.

In implementations, the autoregressive edge geometry neural network may learn to generate elements of the geometrical edge-vector one by one, wherein the elements may express a geometry type (e.g., whenever the index is of the form $1 + i(K + 1)$) and may express a parameter of an associated geometry otherwise. In particular, in implementations, the edge geometry neural network may generate elements from two distinct dictionaries, a dictionary of geometry types and a dictionary of parameters.

In implementations, the autoregressive edge geometry neural network may comprise a transformer decoder (e.g., a masked transformer decoder) and/or a linear layer.

In implementations, the autoregressive edge geometry neural network may comprise mask training and/or teacher forcing. In implementations, training the autoregressive edge geometry neural network may comprise cross-entropy loss.

Alternatively, in implementations, the edge geometry neural network may be non-autoregressive. In implementations, a non-autoregressive edge geometry neural network may learn to generate the sequence $GE^{seq}$ all at a same time. In implementations, the above-defined probability vector may be decomposed as follows:

$$p(GE^{seq}|E^{seq}, O; \theta_{GE}) = \prod_{i=1}^{|GE^{seq}|} p(g_i|E^{seq}, O; \theta_{GE})$$

where $\theta_{GE}$ are learnable parameters of the network.

In implementations, a non-autoregressive edge geometry neural network may comprise embeddings (e.g., a vertex encoder) as the autoregressive edge geometry neural network. In implementations, a non-autoregressive edge geometry neural network may further comprise a transformer decoder. In implementations, a non-autoregressive edge geometry neural network may predict a sequence $GE^{seq} = \{g_1, ..., g_{(K+1) \times n}\}$ given the "starting token" $st$, a topological edge-vector, and a conditioning signal. In implementations, the variables $g_i$ may signify either a geometry type of an edge or a parameter of an associated geometry type. In implementations, training a non-autoregressive edge geometry neural network may comprise cross-entropy loss.

In implementations, the edge geometry neural network may be trained to, given a topological edge-vector (e.g., generated with the edge topology neural network), a vertex-vector (e.g., generated with the vertex neural network), and a conditioning signal representing a geometry, generate a sequence of geometrical edges of a B-rep representing the geometry. In particular, the method of use may generate said geometrical edges given said conditioning signal.

The generative function comprises a face neural network configured to, given the generated edges (e.g., and the generated vertices), generate B-rep topological faces respecting the conditioning signal. The generated edges and/or vertices may be generated with respect to the conditioning signal, e.g., with one of the above-described implementations of vertex neural network. The face neural network may learn the distribution of faces conditioned on the vertices, the edges (topological and/or geometrical), and the conditioning signal representing a geometry.

The face neural network comprises a face topology neural network configured for generating topological faces each defined by a sequence of consecutive generated edges forming a face boundary.

In implementations, the face topology neural network may be a probabilistic neural network. In implementations, the face topology neural network may comprise, e.g., a DNN, a generative model, a transformer, a transformer encoder and/or decoder, a pointer network, or a combination thereof. In implementations, the face topology neural network may be trained using cross-entropy loss.

In implementations, training the face topology neural network may comprise one or more of the above-described pre-processing methods. In particular, in implementations, training the face topology neural network may comprise extracting topological faces, and sorting faces, edges, and/or vertices. Specifically, in implementations, training the face topology neural network may comprise, for each B-rep comprised in the training sample, obtaining a topological face-vector $F^{seq} = \{f_1, f_2, ..., f_n, eos\}$, as explained above. That is, each symbol $f_i$ is either identifying an edge (that are part of the boundary of an associated face) or the symbol that identifies the start of a "new face" $nf$. In implementations, the symbols $f_i$ may correspond to integers, corresponding to an order of the edges, e.g., indexing the last edge in the sequence with $|E|$, where $|E|$ is the total number of edges. In implementations, the face topology neural network may generate topological face-vectors of the same form. In implementations, the symbol "end of sequence" $eos$ may be used to predict the end of the sequence of edges.

In implementations, the face topology neural network may comprise embeddings and/or encodings, e.g., the embeddings and/or encodings comprising the embeddings and/or encodings of the implementations of the previously defined neural networks or variation thereof. The embeddings and/or encoding may further comprise quantizing parameters.

In implementations, given a conditioning signal representing a geometry $O$, a topological edge-vector $E^{seq}$, a geometrical edge-vector $GE^{seq}$, and a vertex-vector $V^{seq}$, the face topology neural network may learn the probability vector $p(F^{seq}|E^{seq}, GE^{seq}, V^{seq}, O)$, that is, the probability that the conditioning signal, the topological edge vector, the geometrical edge-vector, and the vertex-vector are associated with the topological face-vector $F^{seq}$. The probability vector may be associated to a distribution defined over edges indexes and/or symbols (e.g., $nf$, $eos$).

In implementations, the face topology neural network may be autoregressive. In implementations, the autoregressive face topology neural network may learn to generate the sequence $F^{seq}$ element by element, each generation using the previous generation. Each generation may consist of an edge composing the boundary of a face or a symbol, such as the symbol for "new face" $nf$, or the symbol for "end of sequence". That is, in implementations, the above-defined probability vector may be decomposed as follows:

$$p(F^{seq}|E^{seq}, GE^{seq}, V^{seq}, O; \theta_F)$$

$$= \prod_{i=1}^{|F^{seq}|} p(f_i|f_1, f_2, ..., f_{i-1}, E^{seq}, GE^{seq}, V^{seq}, O; \theta_F)$$

where $\theta_F$ are the learnable parameters of the network. In other words, the goal of the autoregressive face topology neural network may be to predict a next edge index $f_i$, based on previous vertex indices $f_{<i}$, the conditioning signal $O$ and the vectors $GE^{seq}$, $E^{seq}$, and $V^{seq}$.

In implementations, the autoregressive face topology neural network may comprise embeddings (e.g., encodings). Embeddings may comprise one or more learnable matrices (i.e., matrices with learnable parameters). In implementations, embeddings may comprise encoding the vertices (e.g., an edge encoder). In implementations, embeddings may further comprise combining and/or concatenating one or more steps (e.g., one or more learnable matrices) into a single embedding (e.g., a single matrix). In implementations, embeddings may comprise a linear layer.

In implementations, embeddings (e.g., an edge encoder) may comprise three types of value embeddings based on the three coordinates (e.g., the three coordinates of the vertices). In implementations, the three embeddings may be concatenated to create a single embedding and/or a linear layer may be applied.

In implementations, embeddings (e.g., an edge encoder) may comprise an embedding for each edge. In implementations, the embedding of an edge may comprise an embedding summing the vertex embeddings of the vertices comprising the boundary of the edge. In implementations, the sum may be further summed to the embeddings of the parameters of the edge. In implementations, the symbols "new face" *nf* and "end of sequence" *eos* may be encoded with learnable embeddings.

In implementations, embeddings may further comprise a transformer encoder. In implementations, embeddings may result in a matrix $H_{edge}$ of shape $[|E| + 2, d]$ where $|E|$ represents the total number of edges.

In implementations, the autoregressive face topology neural network may comprise mask training and/or teacher forcing. In implementations, training the autoregressive face topology neural network may comprise obtain as input sequence $F^{in} = \{st, f_1, f_2,..., f_n\}$ and encoding the input sequence. In implementations, the encoding may comprise gathering the embeddings from $H_{edge}$ that corresponds to the edges, *nf* and *eos*. In implementations, the learned positional embeddings indicating the position of each token in the sequence may further be added.

In implementations, the autoregressive face topology neural network may comprise a pointer network and a masked transformer decoder followed by a linear layer to produce a pointer vector. In each step of the autoregressive model, the pointer network may compute the dot-product between the pointer vector and the embeddings $H_{edge}$. In implementation, the autoregressive face topology neural network may further comprise a softmax operation, the softmax operation being applied to normalize these scores, resulting in a distribution over edge indices, *nf* and *eos.*

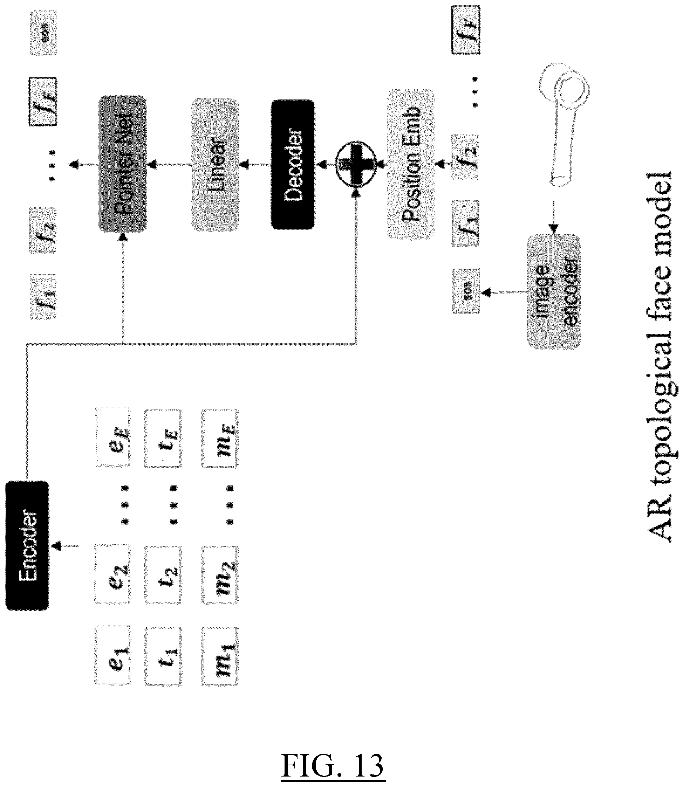

FIG. 13 illustrates an implementation of the autoregressive face topology neural network, comprising image encoder, embeddings, a transformer encoder and decoder model, a linear model, a pointer network, and a softmax step.

Alternatively, the face topology neural network may be non-autoregressive. In implementations, the non-autoregressive face topology neural network may learn to generate the sequence $F^{seq}$ all at a same time. In implementations, the above-defined probability vector may be decomposed as follows:

$$p(F^{seq}|E^{seq}, GE^{seq}, V^{seq}, O; \theta_F) = \prod_{i=1}^{|F^{seq}|} p(f_i|E^{seq}, GE^{seq}, V^{seq}, O; \theta_F)$$

where $\theta_F$ are the learnable parameters of the network.

In implementations, the non-autoregressive face topology neural network may comprise embeddings, e.g., an edge encoder. In implementations, the edge encoder may be the same as the autoregressive model. In implementations, the non-autoregressive face topology neural network may comprise a transformer decoder. In implementations, the non-autoregressive face topology neural network may generate an output sequence $F^{out} = \{f_1, f_2,...,f_n, eos\}$ starting from an input sequence $F^{in} = \{st, f_1, f_2,..., f_n\}$.

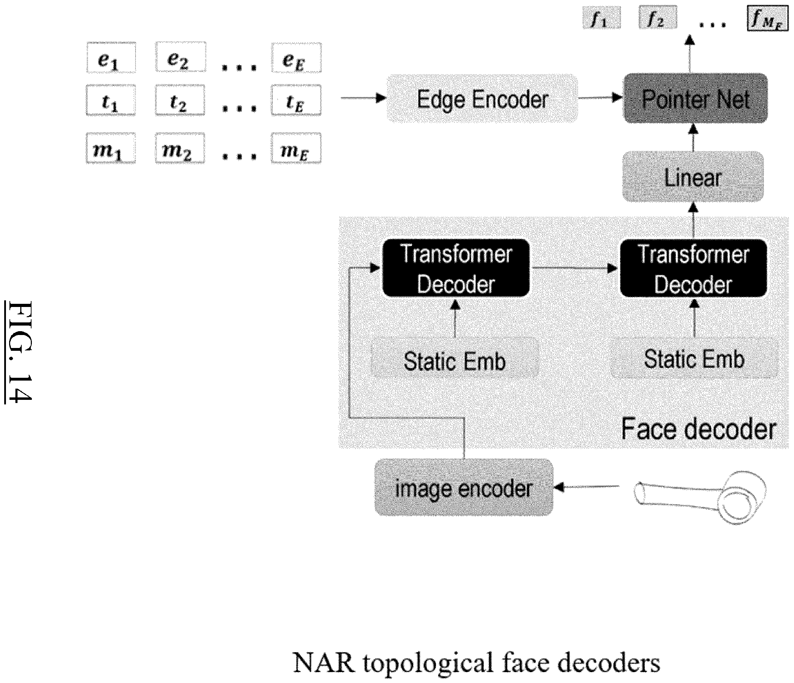

FIG. 14 illustrates an implementation of the non-autoregressive face topology neural network, comprising image encoder, embeddings, a transformer decoder models, linear models, and a pointer network.

In implementations, the face topology neural network may be trained to, given a geometrical edge-vector (e.g., generated with the edge geometry neural network), a topological edge-vector (e.g., generated with the edge topology neural network), a vertex-vector (e.g., generated with the vertex neural network), and a conditioning signal representing a geometry, generate a sequence of face of a B-rep representing the geometry. In particular, the method of use may generate said faces given said conditioning signal.

The face neural network further comprises a face geometry neural network configured for determining geometries of the generated faces. In implementations, the face geometry neural network may be a probabilistic neural network. In implementations, the face geometry neural network may comprise, e.g., a DNN, a generative model, a transformer, or a combination thereof. In implementations, the face geometry neural network may be trained using cross-entropy loss.

In implementations, training the face geometry neural network may comprise one or more of the above-described pre-processing methods. For example, in implementations, training the face geometry neural network may comprise extracting the geometrical faces, and sorting faces, edges, and/or vertices. Specifically, in implementations, training the face geometry neural network may comprise, for each B-rep comprised in the training sample, obtaining a geometrical face-vector $GF^{seq} = \{t_1, p_{1,1}, ..., p_{1,K}, ..., t_n, p_{n,1}, ..., p_{n,K}\}$ as explained above.

In implementations, the face geometry neural network may comprise embeddings and/or encodings, e.g., embeddings and/or encodings comprising (e.g., consisting of) embeddings and/or encodings introduced in the implementations of the previously defined neural networks or variation thereof. The embeddings and/or encoding may further comprise quantizing parameters.

In implementations, training the face geometry neural network may comprise computing a loss (e.g., with a cross-entropy loss) and the tokens corresponding to non-required parameters by a given geometry may be discarded for the loss computation.

In implementations, the face geometry neural network may be autoregressive. In implementations, the autoregressive face geometry neural network may learn to generate the sequence $GF^{seq}$ element by element, each generation using the previous generation. Each generation may consist of a geometry type, a geometry parameter for an associated face, or a symbol, such as the "end of sequence" symbol. In implementations, the generation of the geometry types may follow an order on the faces and the geometry parameter may follow the associated geometry type.

In implementations, the autoregressive face geometry neural network may learn to generate elements of the geometrical face-vector one by one, wherein the elements may express a geometry type and may express a parameter of an associated geometry otherwise. In particular, in implementations, the face geometry neural network may generate elements from two distinct dictionaries, a dictionary of geometry types and a dictionary of parameters.

In implementations, the autoregressive face geometry neural network may comprise a transformer decoder (e.g., a masked transformer decoder) and/or a linear layer.

In implementations, the autoregressive face geometry neural network may comprise mask training and/or teacher forcing. In implementations, training the autoregressive face geometry neural network may comprise cross-entropy loss.

Alternatively, in implementations, the face geometry neural network may be non-autoregressive. In implementations, a non-autoregressive face geometry neural network may learn to generate the sequence $GF^{seq}$ all at a same time.

In implementations, a non-autoregressive face geometry neural network may comprise embeddings (e.g., a vertex encoder) as the autoregressive face geometry neural network. In implementations, a non-autoregressive face geometry neural network may further comprise a transformer decoder. In implementations, a non-autoregressive face geometry neural network may predict a sequence $GF^{seq}$ given the "starting token" $st,$ a topological face-vector, and a conditioning signal. In implementations, training a non-autoregressive face geometry neural network may comprise cross-entropy loss.

In implementations, the face geometry neural network may be trained to, given a topological face-vector (e.g., generated with the face topology neural network), a geometrical edge-vector (e.g., generated with the edge geometry neural network), a topological edge-vector (e.g., generated with the edge topology neural network), a vertex-vector (e.g., generated with the vertex neural network), and a conditioning signal representing a geometry, generate a sequence of geometrical faces of a B-rep representing the geometry. In particular, the method of use may generate said geometrical faces given said conditioning signal.

In implementations, one or more of the above neural networks may be combined together.

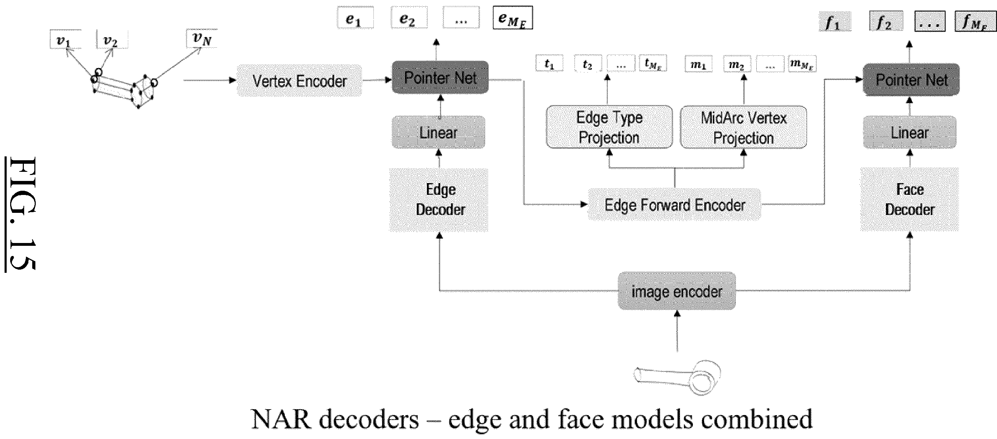

FIG. 15 illustrates an implementation of the topological edge and the face model combined together, to predict the edge and face sequences given the predicted vertices.

In implementations, the learning method may comprise a post-processing step. The post-processing step may comprise methods to modify and/or adjust the outputs of the neural networks.

Examples of the learning method and of the method of use were implemented. The implementations were trained on a dataset comprising training samples consisting of B-reps and sketches representing the B-rep. The core idea of the implemented models was to learn a sketch image embedding and then condition the models using this embedding. This latter serves as a starting token to initialize the sequences of vertices, edges, and faces. This approach aims to generate a B-Rep object that closely resembles the input sketch.

In the implementations, a pre-trained image encoder was used to obtain the sketch embedding which is used as a starting token for all the models. Moreover, in order to make the model capable of detecting every viewing angle, during each forward pass of the training, the implementations comprised randomly selecting one sketch image from a set of seven sketch images with different viewing angles.

In the implementations, after that the model was trained, each sketch image was given as input to the image decoder, yielding a sketch embedding. Then, this embedding was used as input to the vertex, edge and face models to generate the sequence of vertices, edges and faces.

FIG. 16 illustrates the results of an implementation of the methods using autoregressive neural networks and using greedy sampling strategy. The generative function was trained on 260000 single parts, some of the single parts being obtained from multi-part objects.

FIG. 17 illustrates the results of an implementation of the methods using non-autoregressive neural networks. The generative function was trained on 86000 single parts, some of the single parts being obtained from multi-part objects.

The results of the implementations of FIG.s 16-17 are B-reps that very closely resemble the associated sketches, proving the efficacy of the method. Notably, the sketches are of very low quality and with plenty of noise, but still the implementations were able to grasp the geometry of the sketches in the B-reps.

The learning method and the method of use generally manipulate modeled objects, such as B-reps. A modeled object is any object defined by data stored, e.g., in the database. By extension, the expression "modeled object" designates the data itself. According to the type of the system, the modeled objects may be defined by different kinds of data. The system may indeed be any combination of a CAD system and/or a CAM system. In those different systems, modeled objects are defined by corresponding data. One may accordingly speak of CAD object, CAM object, CAD data, CAM data. However, these systems are not exclusive to one of the other, as a modeled object may be defined by data corresponding to any combination of these systems. A system may thus well be both a CAD and/or CAM system.

By CAD solution (*e.g.* a CAD system or a CAD software), it is additionally meant any system, software or hardware, adapted at least for designing a modeled object, such as a B-rep, on the basis of a graphical representation of the modeled object and/or on a structured representation thereof (*e.g.* a feature tree), such as CATIA. In this case, the data defining a modeled object comprise data allowing the representation of the modeled object. A CAD system may for example provide a representation of CAD modeled objects, such as B-reps, using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 2D or 3D modeled object, e.g. representing a product such as a part or an assembly of parts, or possibly an assembly of products. The 2D or 3D modeled object may be a manufacturing product, *i.e.* a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA®.

The learning method and method of use are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the method may be performed through user-computer interaction (e.g., obtaining a conditioning signal representing a geometry in the method of use). The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 18 shows an example of the system, wherein the system is a client computer system, e.g., a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1. A computer-implemented method of machine-learning, for learning a generative function configured to generate a B-rep given a conditioning signal representing a geometry, the generative function comprising:

   - a vertex neural network configured to generate B-rep vertices respecting the conditioning signal;
   - an edge neural network configured to, given the generated vertices, generate B-rep edges respecting the conditioning signal, the edge neural network comprising:

      o an edge topology neural network configured for generating edge connections between the generated vertices; and
      ○ an edge geometry neural network configured for determining geometries of the generated edge connections; and

   - a face neural network configured to, given the generated edges, generate B-rep faces respecting the conditioning signal, the face neural network comprising:

      ○ a face topology neural network configured for generating faces each defined by a sequence of consecutive generated edges forming a face boundary; and
      ○ a face geometry neural network configured for determining geometries of the generated faces;

   the method comprising:

      - obtaining a training dataset including training examples, each training example comprising a B-rep and an associated conditioning signal representing a geometry represented by the B-rep; and
      - training the generative function based on the training dataset.

2. The method of claim 1, wherein one or more of the neural networks are based on a transformer neural network architecture.

3. The method of any one of claims 1 to 2, wherein each determined geometry of a respective generated edge connection is a line, an arc, a B-spline, or a NURBS and/or each determined geometry of a respective generated face connection is a plane, a cylinder, a torus, a cone, a sphere, or a NURBS.

4. The method of any one of claims 1 to 3, wherein the conditioning signal represents an image or a text, said image being a sketch, a picture, or a scan of at least part of an object.

5. The method of claim 4, wherein the generative function includes an encoder, the encoder being configured to take as input the image or the text and encoding it into a vector forming the conditioning signal.

6. The method of any one of claims 1 to 5, wherein the edge topology neural network is based on a pointer network and/or the face topology neural network is based on a pointer network.

7. The method of any one of claims 1 to 6, wherein one or more neural networks are trained to predict elements one at a time, each prediction using all the previous predictions.

8. The method of claim 7, wherein the one or more neural networks are trained following the method of teacher forcing.

9. The method of any one of claims 1 to 8, wherein one or more neural networks are trained to predict all the elements at the same time.

10. The method of any one of claims 1 to 9, wherein the method further includes, prior to the training of the neural networks, pre-processing the training dataset, said pre-processing including normalizing the size of the B-reps, removing loops by adding vertices, bounding box centering, and/or sorting vertices, edges and/faces.

11. A generative function obtainable according to the method of any one of claims 1 to 10.

12. A computer-implemented method of use of the function of claim 11, the method of use comprising:

   - obtaining a conditioning signal representing a geometry; and
   - applying the generative function to generate a B-rep based on the conditioning signal.

13. A computer program comprising instructions which, when executed by a computer system, cause the computer system to perform the method according to any one of claims 1 to 10 and/or the method of claim 12.

14. A computer-readable data storage medium having recorded thereon the computer program of claim 13 and/or the function of claim 11.

15. A computer system comprising a processor coupled to a memory, the memory having recorded thereon the computer program of claim 13 and/or the function of claim 11.

FIG. 1

NURBS          ARC          CIRCLE          LINE

## FIG. 2

PLANE     CYLINDER     TORUS     SPHERE     CONE     NURBS

## FIG. 3

2D Sketch

BRep model

FIG. 4

Single-part Object

2* Single-part Object

Multi-part Object

Multi-parts decomposition

FIG. 5

FIG. 6

FIG. 7

AR vertex model

FIG. 8

NAR vertex encoder

FIG. 9

FIG. 10

AR topological edge model

Vertex Encoder

FIG. 11

FIG. 12

FIG. 13

FIG. 14

NAR topological face decoders

NAR decoders – edge and face models combined

## FIG. 15

FIG. 16

FIG. 17

FIG. 18

Europäisches
Patentamt

European
Patent Office

Office européen
des brevets

# EUROPEAN SEARCH REPORT

**Application Number**

EP 25 30 5065

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 421 684 A1 (AUTODESK INC [US]) 28 August 2024 (2024-08-28) * paragraph [0019] - paragraph [0100]; figures 1-9 * | 1-15 | INV. G06F30/27 G06N3/045 G06V10/82 |
| A | XIANG XU ET AL: "BrepGen: A B-rep Generative Diffusion Model with Structured Latent Geometry", ARXIV.ORG, CORNELL UNIVERSITY LIBRARY, 201 OLIN LIBRARY CORNELL UNIVERSITY ITHACA, NY 14853, 16 May 2024 (2024-05-16), XP091757427, * Abstract; pages 2-6; sections 2-5 * | 1-15 | |
| A | JAYARAMAN PRADEEP KUMAR ET AL: "UV-Net: Learning from Boundary Representations", 2021 IEEE/CVF CONFERENCE ON COMPUTER VISION AND PATTERN RECOGNITION (CVPR), IEEE, 20 June 2021 (2021-06-20), pages 11698-11707, XP034006964, DOI: 10.1109/CVPR46437.2021.01153 [retrieved on 2021-10-15] * Abstract; pages 11700-11705; sections 3-5 * | 1-15 | |

**TECHNICAL FIELDS SEARCHED (IPC)**

G06F
G06V
G06N

The present search report has been drawn up for all claims

| Place of search | Date of completion of the search | Examiner |
|---|---|---|
| Munich | 22 April 2025 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .......................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 30 5065

This annex lists the patent family members relating to the patent documents cited in the above-mentioned European search report.
The members are as contained in the European Patent Office EDP file on
The European Patent Office is in no way liable for these particulars which are merely given for the purpose of information.

22-04-2025

| Patent document cited in search report | | Publication date | Patent family member(s) | | Publication date |
|---|---|---|---|---|---|
| EP 4421684 | A1 | 28-08-2024 | EP | 4421684 A1 | 28-08-2024 |
| | | | US | 2024289502 A1 | 29-08-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PRADEEP KUMAR JAYARAMAN** ; **JOSEPH G. LAMBOURNE** ; **NISHKRIT DESAI** ; **KARL D.D. WILLIS** ; **ADITYA SANGHI** ; **NIGEL J.W. MORRIS**. SolidGen: An Autoregressive Model for Direct B-rep Synthesis. *TMLR*, 2023

- Pointer Networks. **ORIOL VINYALS, MEIRE FORTUNATO** ; **NAVDEEP JAITLY**. Advances in Neural Information Processing Systems. Curran Associates, Inc., 2015, vol. 28